# EUROPEAN PATENT SPECIFICATION

(11) **EP 2 458 629 B1**
(45) Date of publication and mention of the grant of the patent: **15.05.2019**
(21) Application number: 10802081.9
(22) Date of filing: 21.07.2010
(51) Int. Cl.: H01L 21/683, H01L 21/02, H01L 21/67

(54) **SUBSTRATE PROCESSING SYSTEM, SUBSTRATE HOLDER, SUBSTRATE HOLDER PAIR, SUBSTRATE JOINING APPARATUS AND DEVICE MANUFACTURING METHOD**
SUBSTRATVERARBEITUNGSSYSTEM, SUBSTRATHALTER, SUBSTRATHALTERPAAR, SUBSTRATVERBINDUNGSVORRICHTUNG UND VERFAHREN ZUR HERSTELLUNG DIESER VORRICHTUNG
SYSTÈME DE TRAITEMENT DE SUBSTRATS, PORTE-SUBSTRAT, PAIRE DE PORTE-SUBSTRATS, APPAREIL D'ASSEMBLAGE DE SUBSTRATS ET PROCÉDÉ DE FABRICATION DE DISPOSITIF

(30) Priority: 21.07.2009 JP 2009170513; 04.11.2009 JP 2009253439; 04.11.2009 JP 2009253440; 04.02.2010 JP 2010023510
(43) Date of publication of application: 30.05.2012
(73) Proprietor: Nikon Corporation, Tokyo 108-6290 (JP)
(72) Inventor: SUGAYA, Isao, Tokyo 100-8331 (JP); CHONAN, Junichi, Tokyo 100-8331 (JP); MAEDA, Hidehiro, Tokyo 100-8331 (JP); TANAKA, Keiichi, Tokyo 100-8331 (JP); YASUDA, Tomoyuki, Tokyo 100-8331 (JP)
(74) Representative: Hoffmann Eitle
(86) International application number: PCT/JP2010/004675
(87) International publication number: WO 2011/010460

(56) References cited:
- WO-A1-2009/057710
- WO-A1-2009/057710
- JP-A- 5 217 973
- JP-A- 2005 203 645
- JP-A- 2006 344 613

## Description

### TECHNICAL FIELD

The present invention relates to a substrate holder pair, a substrate bonding apparatus, and a device manufacturing method.

### BACKGROUND ART

A known layered semiconductor apparatus is formed by layering semiconductor substrates that each have elements, circuits, and the like formed thereon. When layering the semiconductor substrates, a pair of semiconductor substrates supported by substrate holders are positioned with a degree of accuracy corresponding to the line width of the semiconductor circuits and then layered, after which the entirety of each substrate is heated and pressurized to achieve bonding. At this time, a positioning apparatus that fixes the position of the pair of semiconductor substrates and a heating and pressurizing apparatus that realizes the permanent bonding via pressurization and heating are used.

Further, WO 2009/057710 A1 discloses a substrate holding unit that holds a pair of substrates that are aligned and layered, comprising a first holding member that holds one of the substrates; a plurality of members to be joined that are connected to the first holding member; a second holding member that holds the other of the substrates to face the one of the substrates; a plurality of joining members that exert an adhesion force on the members to be joined and are connected to the second holding member at positions corresponding to positions of the members to be joined; and an adhesion restricting section that restricts the adhesion force until the substrates are aligned.

### [Prior Art Documents]

### [Patent Documents]

Patent Document 1: Japanese Patent Application Publication No. H11-261000
Patent Document 2: Japanese Patent Application Publication No. 2005-251972
Patent Document 3: Japanese Patent Application Publication No. 2007-115978

### DISCLOSURE OF THE INVENTION

### PROBLEMS TO BE SOLVED BY THE INVENTION

When two semiconductor substrates are layered, if even a small amount of dust is trapped between the semiconductor circuit regions facing each other, the circuit operations becomes unacceptable. Furthermore, this can lead to localized occurrences of insufficient pressurization and heating, resulting in insufficient bonding strength.

Therefore, it is an object of an aspect of the innovations herein to provide a substrate processing system, a substrate holder, a substrate holder pair, a substrate bonding apparatus, and a device manufacturing method, which are capable of overcoming the above drawbacks accompanying the related art. The above and other objects can be achieved by combinations described in the independent claims. The dependent claims define further advantageous and exemplary combinations of the innovations herein.

### MEANS FOR SOLVING THE PROBLEMS

According to a first aspect of the present invention, provided is a substrate holder comprising a dust flow inhibiting mechanism that inhibits flow of dust into a region for holding a substrate.

According to a second aspect of the present invention, provided is a substrate holder comprising a holder body having a holding surface for holding a substrate; and an engaging member provided on a peripheral portion of a substrate holding region on the holding surface. A protruding portion is formed on a counterface surface of the engaging member that faces an engagement receiving member, in a manner to achieve point contact or linear contact with the engagement receiving member.

According to a third aspect of the present invention, provided is a device manufacturing method comprising manufacturing a device by stacking a plurality of substrates. Stacking the plurality of substrates includes mounting at least one of the plurality of substrates on a substrate holder that includes an engaging member provided on a periphery of a substrate holding region on a holding surface thereof for holding a substrate and that includes a protruding portion formed on a counterface surface of the engaging member that faces an engagement receiving member, in a manner to achieve point contact or linear contact with the engagement receiving member.

According to a fourth aspect of the present invention, provided is a substrate processing system comprising a substrate holder system that causes a first substrate holder holding a first substrate and a second substrate holder holding a second substrate to face each other and sandwiches the first substrate and the second substrate; and a processing apparatus that holds the substrate holder system. At least one of the substrate holder system and the processing apparatus includes a dust flow inhibiting mechanism that inhibits flow of dust into a region sandwiching the first substrate and the second substrate.

According to a fifth aspect of the present invention, provided is a substrate processing system comprising a substrate holder system that causes a first substrate holder holding a first substrate and a second substrate holder holding a second substrate to face each other and sandwiches the first substrate and the second substrate; a processing apparatus that holds the substrate holder system; an engagement receiving member provided on the first substrate holder; and an engaging member provided on the second substrate holder and facing the engagement receiving member. When the substrate holder system is held by the processing apparatus, contact surfaces of the engaging member and the engagement receiving member are positioned below bonding surfaces of the first substrate and the second substrate in a direction of gravity.

According to a sixth aspect of the present invention, provided is a device manufacturing method comprising manufacturing a device by stacking a plurality of substrates. Stacking the plurality of substrates includes, in a substrate processing system having a substrate holder system that causes a first substrate holder holding a first substrate from among the plurality of substrates and a second substrate holder holding a second substrate from among the plurality of substrates to face each other and sandwiches the first substrate and the second substrate and a processing apparatus that holds the substrate holder system, when the substrate holder system is held by the processing apparatus, holding the first substrate and the second substrate such that contact surfaces of an engaging member provided on the second substrate holder and an engagement receiving member provided on the first substrate holder are at positions below bonding surfaces of the first substrate and the second substrate in a direction of gravity.

According to a seventh aspect of the present invention, provided is a substrate holder pair comprising a first substrate holder on which a first substrate is mounted; a second substrate holder on which a second substrate is mounted; and a dust flow inhibiting mechanism that, when the first substrate and the second substrate are sandwiched by the first substrate holder and the second substrate holder, inhibits flow of dust toward the first substrate and the second substrate.

According to an eighth aspect of the present invention, provided is a substrate holder pair comprising a first substrate holder including a first mounting region on which a first substrate is mounted and a first engaging section provided on a periphery of the first mounting region; a second substrate holder including a second mounting region on which a second substrate is mounted and a second engaging section provided on a periphery of the second mounting region; and a dust flow inhibiting mechanism that, in a state where the first mounting region and the second mounting region face each other and the first engaging section and the second engaging section are engaged with each other, inhibits flow of dust to the first mounting region and the second mounting region. The dust flow inhibiting mechanism is provided between the first engaging section and the first mounting region of the first substrate holder and/or between the second engaging section and the second mounting region of the second substrate holder.

According to a ninth aspect of the present invention, provided is a device manufacturing method comprising manufacturing a device by stacking a plurality of substrates, wherein stacking the plurality of substrates includes mounting a first substrate on a first substrate holder including a first mounting region on which the first substrate is mounted and a first engaging section provided on a periphery of the first mounting region; mounting a second substrate on a second substrate holder including a second mounting region on which the second substrate is mounted and a second engaging section provided on a periphery of the second mounting region; and forming the first substrate holder and the second substrate holder integrally by engaging the first engaging section and the second engaging section with each other, while inhibiting flow of dust to the first mounting region and the second mounting region using a dust flow inhibiting mechanism provided between the first engaging section and the first mounting region of the first substrate holder and/or between the second engaging section and the second mounting region of the second substrate holder.

According to a tenth aspect of the present invention, provided is a substrate holder that is transported with a substrate mounted thereon, comprising a holder body that includes a mounting region where the substrate is mounted on a front surface thereof; an engaging member that is provided on a periphery of the mounting region and engages with an engagement receiving member; and a dust trapping electrode that is embedded in a dust trapping region between the mounting region and the engaging member in the holder body and traps dust by generating an electrostatic force.

According to an eleventh aspect of the present invention, provided is a substrate holder that is transported with a substrate mounted thereon, comprising a holder body that includes a mounting region where the substrate is mounted on a front surface thereof; and a dust trapping electrode that is embedded in a dust trapping region, which is embedded in the holder body on a side of the mounting region in a transportation direction of the substrate holder, and generates an electrostatic force.

According to a twelfth aspect of the present invention, provided is a device manufacturing method comprising manufacturing a device by stacking a plurality of substrates. Stacking the plurality of substrates includes mounting a first substrate on a first substrate holder including a first mounting region on which the first substrate is mounted and an engaging member provided on a periphery of the first mounting region; mounting a second substrate on a second substrate holder including a second mounting region on which the second substrate is mounted and an engagement receiving member provided on a periphery of the second mounting region; and forming the first substrate holder and the second substrate holder integrally by engaging the engaging member and the engagement receiving member with each other, while generating electrostatic force via conduction in a dust trapping electrode embedded in a dust trapping region provided between the engaging member and the first mounting region of the first substrate holder and/or between the engagement receiving member and the second mounting region of the second substrate holder.

According to a thirteenth aspect of the present invention, provided is a device manufacturing method for manufacturing a device transported in a substrate state. Transporting the substrate includes mounting the substrate on a substrate holder having a mounting region in which the substrate is mounted, and transporting the substrate together with the substrate holder while generating electrostatic force via conduction in a dust trapping electrode embedded in a dust trapping region, which is on a side of the mounting region in a transportation direction of the substrate holder.

According to a fourteenth aspect of the present invention, provided is a device manufacturing method comprising manufacturing a device by stacking a plurality of substrates. Stacking the plurality of substrates includes mounting at least one of the plurality of substrates on a substrate holder including a dust flow inhibiting mechanism that inhibits flow of dust to a region for holding the substrate.

According to a fifteenth aspect of the present invention, provided is a device manufacturing method comprising manufacturing a device by stacking a plurality of substrates. Stacking the plurality of substrates includes mounting a first substrate on a first substrate holder; mounting a second substrate on a second substrate holder; and sandwiching the first substrate and the second substrate between the first substrate holder and the second substrate holder, while using a dust flow inhibiting mechanism to inhibit flow of dust toward the first substrate and the second substrate.

The summary clause does not necessarily describe all necessary features of the embodiments of the present invention. The present invention may also be a subcombination of the features described above as long as it stays within the scope of the appended claims.

### BRIEF DESCRIPTION OF THE DRAWINGS

Fig. 1 schematically shows a substrate bonding apparatus.
Fig. 2 is a planar view schematically showing a semiconductor wafer.
Fig. 3 is a planar view schematically showing the first substrate holder holding the first substrate.
Fig. 4 is a planar view schematically showing the second substrate holder holding the second substrate.
Fig. 5 is a cross-sectional view schematically showing a state immediately before the substrate holder pair is formed.
Fig. 6 is a cross-sectional view schematically showing a state immediately after formation of the substrate holder pair.
Fig. 7 is a perspective view schematically showing the magnet unit.
Fig. 8 is a perspective view schematically showing another example of a magnet unit.
Fig. 9 is a planar view schematically showing a flat spring of an attraction unit.
Fig. 10 is a perspective view schematically showing a state in which the flat spring is elastically deformed.
Fig. 11 is a perspective view including the attracting element when the flat spring of Fig. 10 is in the deformed state.
Fig. 12 is a perspective view schematically showing an exemplary arrangement of spherical protrusions on an attracting element.
Fig. 13 is a cross-sectional view showing the coupling operation between the magnet unit and the attraction unit.
Fig. 14 is a cross-sectional view showing the coupling operation between the magnet unit and the attraction unit.
Fig. 15 is a cross-sectional view schematically showing the engagement control unit.
Fig. 16 is a side view schematically showing a state in which the transport apparatus grips the substrate holder pair.
Fig. 17 is a side view schematically showing essential portions of the bonding apparatus.
Fig. 18 schematically shows a substrate bonding apparatus.
Fig. 19 is a planar view schematically showing a semiconductor wafer.
Fig. 20 is a planar view schematically showing the first substrate holder holding the first substrate.
Fig. 21 is a planar view schematically showing the second substrate holder holding the second substrate.
Fig. 22 is a cross-sectional view schematically showing a state immediately before the substrate holder pair is formed.
Fig. 23 is a cross-sectional view schematically showing a state immediately after formation of the substrate holder pair.
Fig. 24 is a perspective view schematically showing a magnet unit.
Fig. 25 is a planar view schematically showing a flat spring of an attraction unit.
Fig. 26 is a perspective view schematically showing a state in which the flat spring is elastically deformed.
Fig. 27 is a perspective view including the attracting element when the flat spring of Fig. 26 is in the deformed state.
Fig. 28 is a cross-sectional view showing the coupling operation between the magnet unit and the attraction unit.
Fig. 29 is a cross-sectional view showing the coupling operation between the magnet unit and the attraction unit.
Fig. 30 is a vertical cross-sectional view schematically showing the engagement control unit.
Fig. 31 is a side view schematically showing a state in which the transport apparatus grips the substrate holder pair.
Fig. 32 is a side view schematically showing essential portions of the bonding apparatus.
Fig. 33 is a planar view schematically showing a first substrate holder including a dust flow inhibiting mechanism, as a first modification.
Fig. 34 is a planar view schematically showing a first substrate holder including a dust flow inhibiting mechanism, as a second modification.
Fig. 35 is a planar view schematically showing a second substrate holder including a dust flow inhibiting mechanism according to the second modification.
Fig. 36 is a cross-sectional view schematically showing a state immediately after formation of the substrate holder pair according to the second modification.
Fig. 37 is a perspective view schematically showing a magnet unit including a dust flow inhibiting mechanism, as a third modification.
Fig. 38 is a cross-sectional view of a state in which the magnet unit with the shield attached thereto contacts the attraction unit.
Fig. 39 schematically shows a substrate bonding apparatus.
Fig. 40 is a planar view schematically showing a semiconductor wafer.
Fig. 41 is a planar view schematically showing the first substrate holder holding the first substrate.
Fig. 42 is a planar view schematically showing the second substrate holder holding the second substrate.
Fig. 43 is a cross-sectional view schematically showing a state immediately before the substrate holder pair is formed.
Fig. 44 is a cross-sectional view schematically showing a state immediately after formation of the substrate holder pair.
Fig. 45 is a perspective view schematically showing the magnet unit.
Fig. 46 is a planar view schematically showing a flat spring of the attraction unit.
Fig. 47 is a perspective view schematically showing a state in which the flat spring is elastically deformed.

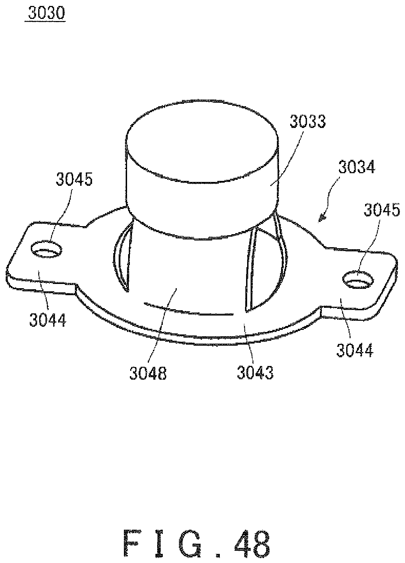

Fig. 48 is a perspective view including the attracting element when the flat spring of Fig. 47 is in the deformed state.
Fig. 49 is a cross-sectional view showing the coupling operation between the magnet unit and the attraction unit.
Fig. 50 is a cross-sectional view showing the coupling operation between the magnet unit and the attraction unit.
Fig. 51 is a cross-sectional view schematically showing the engagement control unit.
Fig. 52 is a side view schematically showing a state in which the transport apparatus grips the substrate holder pair.
Fig. 53 is a side view schematically showing essential portions of the bonding apparatus.
Fig. 54 is a planar view schematically showing a first substrate holder including a dust trapping region, as a first modification.
Fig. 55 is a planar view schematically showing a first substrate holder including a dust trapping region, as a second modification.
Fig. 56 is a planar view schematically showing a first substrate holder including a dust trapping region, as a third modification.

### BEST MODE FOR CARRYING OUT THE INVENTION

Hereinafter, some embodiments of the present invention will be described. The embodiments do not limit the invention according to the claims, and all the combinations of the features described in the embodiments are not necessarily essential to means provided by aspects of the invention.

### (First Embodiment)

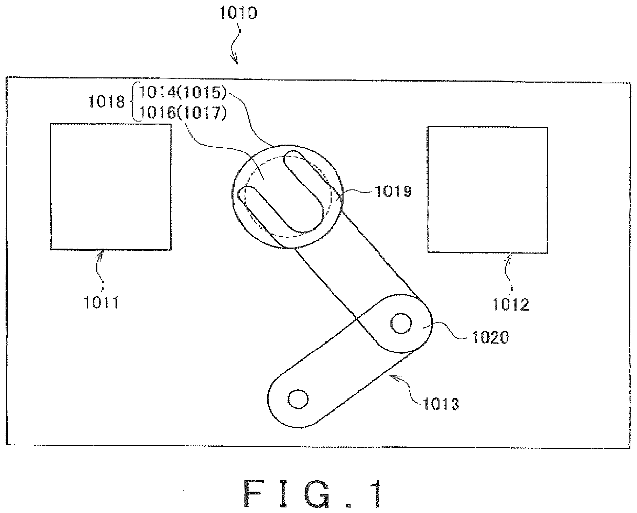

Fig. 1 schematically shows a substrate bonding apparatus 1010 according to a first embodiment. The substrate bonding apparatus 1010 includes an alignment apparatus 1011 that aligns a first substrate 1016, which is a semiconductor wafer, with a second substrate 1017, which is a semiconductor wafer to be layered on the first substrate 1016. The substrate bonding apparatus 1010 also includes a bonding apparatus 1012 that bonds together the first substrate 1016 and the second substrate 1017 aligned by the alignment apparatus 1011.

The first substrate 1016 is held by the first substrate holder 1014, and the second substrate 1017 is held by the second substrate holder 1015. In the alignment apparatus 1011, when the first substrate 1016 and the second substrate 1017 are aligned, the first substrate holder 1014 and the second substrate holder 1015 sandwich the first substrate 1016 and the second substrate 1017 to form these substrates integrally, thereby forming the substrate holder pair 1018. A detailed structure of the substrate holder pair 1018 is described further below.

The substrate bonding apparatus 1010 further includes a transport apparatus 1013 that transports the substrate holder pair 1018 integrated by the alignment apparatus 1011 to the bonding apparatus 1012. The transport apparatus 1013 can also transport a semiconductor wafer or a single substrate holder between apparatuses. The transport apparatus 1013 includes a gripping section 1019 that grips a gripping target such as the substrate holder pair 1018, and an arm portion 1020 that moves the gripping target to a prescribed position via rotating and extending/contracting movement.

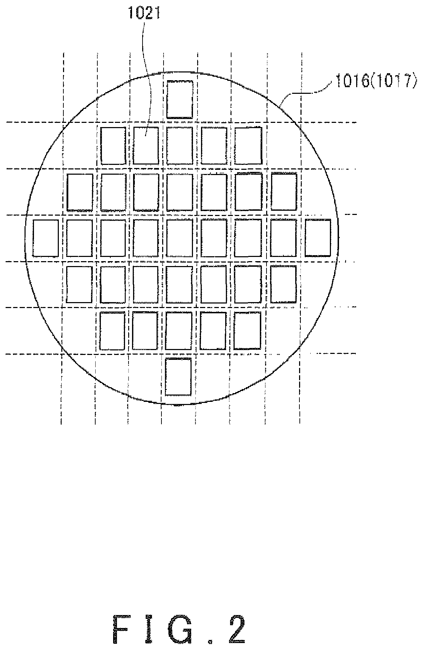

Fig. 2 is a planar view schematically showing a semiconductor wafer according to the present embodiment. The first substrate 1016 and the second substrate 1017, which are semiconductor wafers, are each formed of a circular thin board made of single-crystal silicon, and each have one surface on which a plurality of circuit regions 1021 are formed. The circuit regions 1021 are partitioned into a matrix, and circuit elements such as transistors, resistors, and capacitors are formed therein. The circuit elements are formed using mainly lithography techniques such as thin film formation, etching, or impurity diffusion. Alignment marks are provided within each of the circuit regions 1021. The alignment marks are indicators used to align the substrates with each other. The plurality of alignment marks provided on each of the first substrate 1016 and the second substrate 1017 have their set coordinate values stored independently and managed in a memory. The semiconductor wafers to be layered may be semiconductor wafers that have already been layered with other semiconductor wafers. In this case, the previously layered circuit layers preferably undergo a thinning process to remove unnecessary thickness.

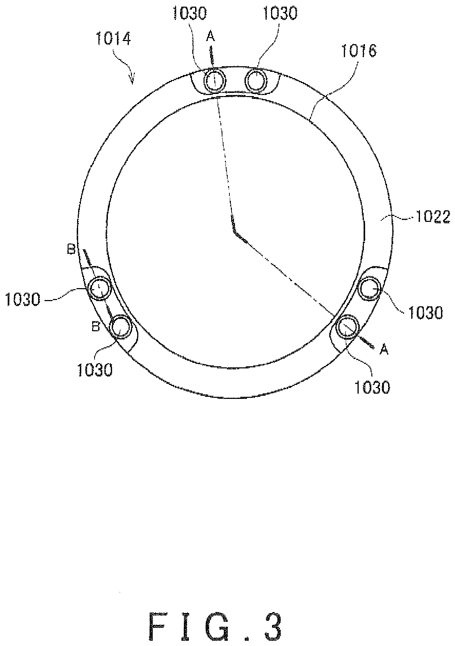

Fig. 3 is a planar view schematically showing the first substrate holder 1014 holding the first substrate 1016. The first substrate holder 1014 includes a holder body 1022 and an attraction unit 1030, and is shaped as a circular board with a diameter larger than that of the first substrate 1016. The holder body 1022 is formed integrally using a material with high rigidity such as ceramic or metal.

The holder body 1022 has a region for holding the first substrate 1016 on the surface thereof. This holding region is polished to be extremely flat. The holding of the first substrate 1016 is achieved by adhesion that uses electrostatic force. Specifically, voltage is applied to an electrode embedded in the holder body 1022, via a voltage application terminal provided on the back surface of the holder body 1022, to cause a potential difference between the first substrate holder 1014 and the first substrate 1016, thereby adhering the first substrate 1016 to the first substrate holder 1014. The adhesion surface of the first substrate 1016 is the surface opposite the surface on which the circuit regions 1021 are provided.

The attraction unit 1030 includes a plurality of peripheral regions, which are arranged further outward than the held first substrate 1016, on the surface thereof that holds the first substrate 1016. In the example shown in the drawings, sets that each include two attraction units 1030 are arranged at intervals of 120 degrees to obtain a total of six attraction units 1030. A more detailed configuration is described further below.

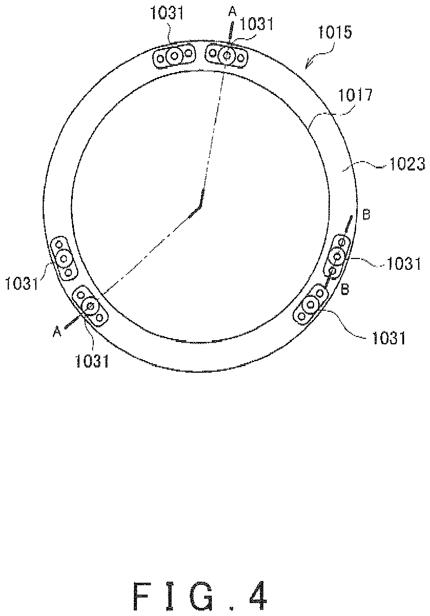

Fig. 4 is a planar view schematically showing the second substrate holder 1015 holding the second substrate 1017. The second substrate holder 1015 includes a holder body 1023 and magnet units 1031, and is shaped as a circular board with a diameter larger than that of the second substrate 1017. The holder body 1023 is formed integrally using a material with high rigidity such as ceramic or metal.

The holder body 1023 has a region for holding the second substrate 1017 on the surface thereof. This holding region is polished to be extremely flat. The holding of the second substrate 1017 is achieved by adhesion that uses electrostatic force. Specifically, voltage is applied to an electrode embedded in the holder body 1023, via a voltage application terminal provided on the back surface of the holder body 1023, to cause a potential difference between the second substrate holder 1015 and the second substrate 1017, thereby adhering the second substrate 1017 to the second substrate holder 1015. The adhesion surface of the second substrate 1017 is the surface opposite the surface on which the circuit regions 1021 are provided.

The magnet unit 1031 includes a plurality of peripheral regions, which are arranged further outward than the held second substrate 1017, on the surface thereof that holds the second substrate 1017. In the example shown in the drawings, sets that each include two magnet units 1031 are arranged at intervals of 120 degrees to obtain a total of six magnet units 1031.

The magnet units 1031 are arranged to correspond respectively to the attraction units 1030 of the first substrate holder 1014. When the first substrate holder 1014 holding the first substrate 1016 and the second substrate 1017 holding the second substrate holder 1015 face each other and the attraction units 1030 and magnet units 1031 are operated, the first substrate 1016 and the second substrate 1017 can be fixed together in a stacked state. This resulting stacked state is the substrate holder pair 1018. A more detailed configuration and the adhesion operation are described further below.

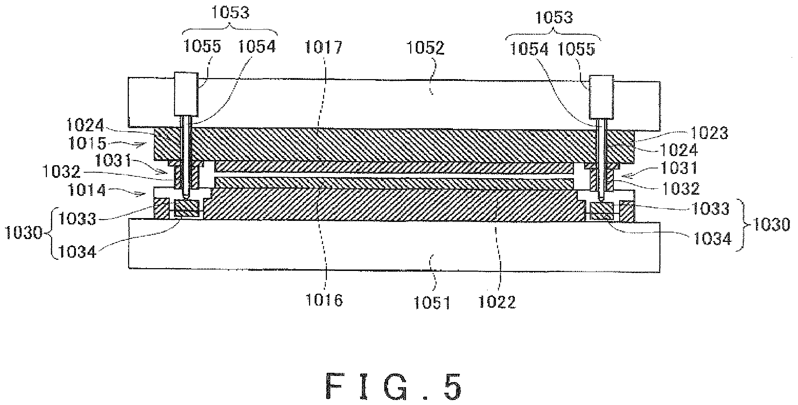

Fig. 5 is a cross-sectional view schematically showing a state immediately before the substrate holder pair 1018 is formed by the alignment apparatus 1011. Specifically, Fig. 5 is a cross-sectional view of a state in which the first substrate holder 1014 holding the first substrate 1016 is fixed to the first stage 1051 of the alignment apparatus 1011 by vacuum suction and the second substrate holder 1015 holding the second substrate 1017 is fixed to the second stage 1052 of the alignment apparatus 1011 by vacuum suction. In particular, the cross-sectional view is over the line A-A in Figs. 3 and 4.

The first stage 1051 can move the first substrate 1016 relative to the second substrate 1017, in a Z-axis direction that is the layering direction and X-axis and Y-axis directions that are each orthogonal to the Z-axis. The alignment apparatus 1011 aligns the first substrate 1016 and the second substrate 1017, by using a first microscope arranged on the alignment apparatus 1011 in a manner to be able to observe the first substrate 1016 and a second microscope arranged on the alignment apparatus 1011 in a manner to be able to observe the second substrate 1017.

More specifically, each microscope is used to capture images of the alignment marks on each substrate serving as an observation target, and precise positions of the alignment marks are detected by performing image processing on the captured image data. The positional skew amount between corresponding alignment marks is then calculated and the first stage 1051 is moved according to this positional skew amount, thereby aligning the first substrate 1016 and the second substrate 1017. In this way, each circuit region 1021 of the first substrate 1016 faces a corresponding circuit region 1021 of the second substrate 1017. The positional skew amount calculation may be performed using a global alignment technique, for example, in which the positional skew amount is statistically determined to have a minimum value when the plurality of alignment marks of the first substrate 1016 overlap the plurality of alignment marks of the second substrate 1017.

When aligning the first substrate 1016 with the second substrate 1017, i.e. when moving the first stage 1051 in the XY-plane, a small gap is maintained between the first substrate 1016 and the second substrate 1017 such that the substrates do not contact each other. The second stage 1052 includes a plurality of engagement control units 1053, such that the attraction units 1030 do not engage with the magnet units 1031 when in this state.

Each engagement control unit 1053 is mainly formed from a push pin 1054, which is a member shaped as a pillar, and a cylinder portion 1055 that drives the push pin 1054, When at an extended position, the push pin 1054 passes through a holder insertion hole 1024 that is provided in the second substrate holder 1015 and a magnet insertion hole 1032 provided in the magnet unit 1031 arranged to be aligned with the holder insertion hole 1024, such that the tip of the push pin 1054 protrudes beyond the magnet insertion hole 1032. When at a storage position, a portion of the push pin 1054 is stored within the cylinder portion 1055, and is withdrawn from the insertion holes. In other words, the push pin 1054 moves back and forth in the Z-axis direction within the insertion holes, according to the drive of the cylinder portion 1055.

When the first substrate 1016 and the second substrate 1017 are to be moved relative to each other in the XY-plane, such as shown in Fig. 5, the push pins 1054 are held at the extended position in contact with the top surfaces of the attraction units 1030, thereby preventing the attraction units 1030 from engaging with the magnet units 1031. In other words, the attraction units 1030 are formed by attracting elements 1033 and flat springs 1034 fixed to the attracting elements 1033, but the push pins 1054 press on the attracting elements 1033 from above to restrict the elastic deformation of the flat springs 1034, such that the attracting elements 1033 do not engage with the magnet units 1031 as a result of the elastic deformation of the flat springs 1034.

The alignment of the first substrate 1016 and the second substrate 1017 by the alignment apparatus 1011 is performed at a final fine adjustment stage in which the movement amount is such that the tips of the push pins 1054 slide along the top surfaces of the attraction units 1030. At other stages, such as an observation stage in which the alignment marks are observed by the microscopes, the first substrate 1016 and the second substrate 1017 are separated from each other by a large amount in the X-, Y-, and Z-axis directions, and therefore the attraction units 1030 do not unexpectedly engage with the magnet units 1031. Accordingly, the push pins 1054 are held at the extended position when the magnetic force of the magnet units 1031 is exerted on the attraction units 1030 and engaging therebetween is to be prevented, and are held at the stored position at all other times.

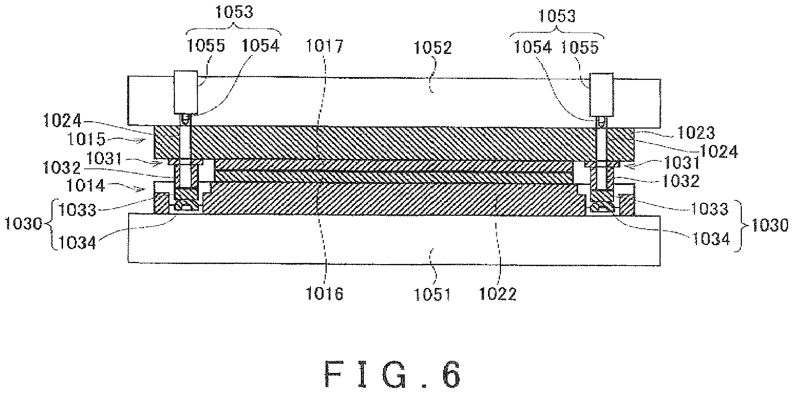

Fig. 6 is a cross-sectional view schematically showing a state immediately after formation of the substrate holder pair 1018 by the alignment apparatus 1011. Specifically, Fig. 6 shows a state in which the first stage 1051 has been driven in the Z-axis direction from the state shown in Fig. 5, such that the surface of the first substrate 1016 contacts the surface of the second substrate 1017, the push pins 1054 are held at the storage position, and the attraction units 1030 and magnet units 1031 are engaged.

During the process of transitioning from the state of Fig. 5 to the state of Fig. 6, the first substrate 1016 and the second substrate 1017 are aligned, and the magnet units 1031, which are engaging members, are engaged with the attraction units 1030, which are engagement receiving members. The first substrate holder 1014 and the second substrate holder 1015 are then formed integrally, thereby forming the substrate holder pair 1018 as the substrate holder system.

The Z-axis direction is the direction of gravitational force in the alignment apparatus 1011, and the first stage 1051 is positioned below the second stage 1052. Therefore, each surface is arranged from top to bottom, in the direction of the gravitational force, in the order of the second substrate 1017 holding surface of the second substrate holder 1015, the bonding surfaces of the second substrate 1017 and the first substrate 1016, and the first substrate 1016 holding surface of the first substrate holder 1014.

During the process of transitioning from the state of Fig. 5 to the state of Fig. 6, the movement of the push pins 1054 to the storage position causes elastic deformation of the flat springs 1034, and so the attraction units 1030 engage with the magnet units 1031. At this time, the engagement of the attracting elements 1033 of attraction units 1030 with the magnet units 1031 is accompanied by a small impact. Therefore, at this time, the contact surfaces of the attracting elements 1033 and the magnet units 1031 in the gravitational force direction are set to be lower than the contact surfaces of the second substrate 1017 and the first substrate 1016. The contact surfaces of the attracting elements 1033 and the magnet units 1031 are preferably set to be lower than the first substrate 1016 holding surface of the first substrate holder 1014.

By setting such a positional relationship, even if dust is created and scattered by the impact of the engagement between the attraction units 1030 and the magnet units 1031, the dust can be expected to be pulled down by gravity and to not enter between the first substrate 1016 and the second substrate 1017. In other words, dust entering between the substrates causes problems in the circuit operation and creates insufficient bonding strength, but these problems can be expected to be avoided by adopting the positional relationship described above.

Furthermore, when the contact surfaces of the attracting elements 1033 and the magnet units 1031 are set below the first substrate 1016 holding surface of the first substrate holder 1014, dust can be prevented from becoming attached to these surfaces. As a result, the first substrate holder 1014 can be kept in a clean state when used repeatedly, and there is no worry that dust will be trapped when the first substrate holder 1014 is mounted on another first substrate 1016. Accordingly, it can be expected that problems such as inclination of the first substrate 1016 and bonding unevenness in the bonding apparatus 1012 will be avoided.

After the substrate holder pair 1018 is formed, the substrate holder pair 1018 is released from the vacuum suction of the second stage 1052, lifted up by the first stage 1051, and transported to the bonding apparatus 1012 by the transport apparatus 1013. The transportation mechanism of the transport apparatus 1013 and the bonding process of the bonding apparatus 1012 are described further below.

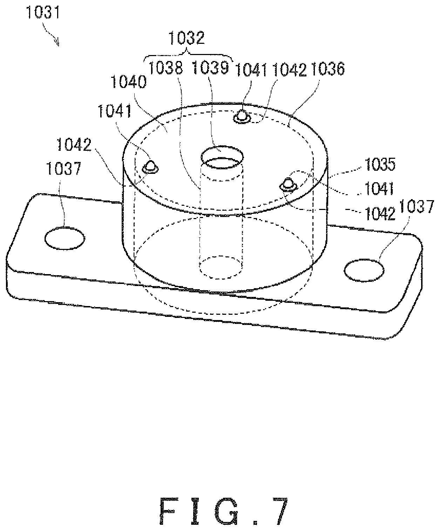

The following describes a configuration of the magnet unit 1031. Fig. 7 is a perspective view schematically showing the magnet unit 1031. The magnet unit 1031 includes a magnet 1036, a support section 1035 housing the magnet 1036, and a plurality of spherical protrusions 1041.

The support section 1035 includes a housing portion shaped as a circular cylinder that houses the magnet 1036, and a threaded hole 1037 through which passes a screw for fixing the support section 1035 to the second substrate 1017. The support section 1035 is formed by carbon steel S25C, for example. The magnet 1036 is a permanent magnet shaped as a circular pillar that can be inserted into the housing portion of the support section 1035, and may have a magnetic force of approximately 8 N, for example. The central axis of the magnet 1036 is provided with an insertion hole 1038 into which is inserted a push pin 1054, and an insertion hole 1039 in series with the insertion hole 1038 and into which the support section 1035 is inserted. The magnet insertion hole 1032 is formed by these two insertion holes.

The support section 1035 includes a counterface surface 1040 that faces the attracting element 1033. At least three spherical protrusions 1041 are embedded in the counterface surface 1040. The spherical protrusions 1041 are embedded and fixed by being pressed in fixing members 1042, which are brass rings formed on the counterface surface 1040, for example. As another example, the counterface surface 1040 of the support section 1035 may be machined using polishing, for example, such that the spherical protrusions 1041 are formed integrally with the support section 1035.

By forming the spherical protrusions 1041 in this way, point contact can be achieved between the magnet unit 1031 and the attracting element 1033. In other words, since the virtual surface formed by the spherical protrusions 1041 is the contact surface that contacts the attracting element 1033, the surface are of the contact can be greatly reduced, and the occurrence of dust can be significantly restricted.

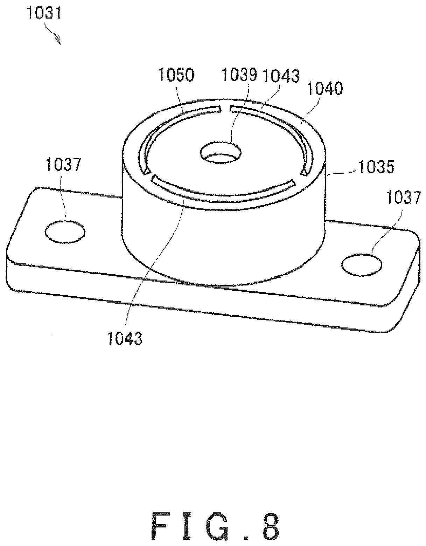

Fig. 8 is a perspective view schematically showing another example of a magnet unit 1031. This magnet unit 1031 differs from the magnet unit 1031 of Fig. 7 in that linear protrusions 1050, which are protruding portions having triangular cross sections, are formed on the counterface surface 1040. The linear protrusions 1050 may be formed integrally with the support section 1035 by machining the counterface surface 1040 of the support section 1035 via polishing, for example, or may be separate bodies attached to the counterface surface 1040.

By forming the linear protrusions 1050 in this way, line contact can be achieved between the magnet unit 1031 and the attracting element 1033. If the cross sections of the linear protrusions 1050 are triangular, for example, the virtual surface formed by a straight line connecting the peak edges is the contact surface that contacts the attracting element 1033, and therefore the surface area of the contact can be greatly reduced, and the occurrence of dust can be significantly restricted. The cross-sectional surface is not limited to a triangular shape, and any shape may be used that can achieve substantially linear contact. Furthermore, even if a small flat portion remains on the contact portion as a result of the polishing process, for example, this small flat portion is still acceptable as long as it can achieve substantially linear contact.

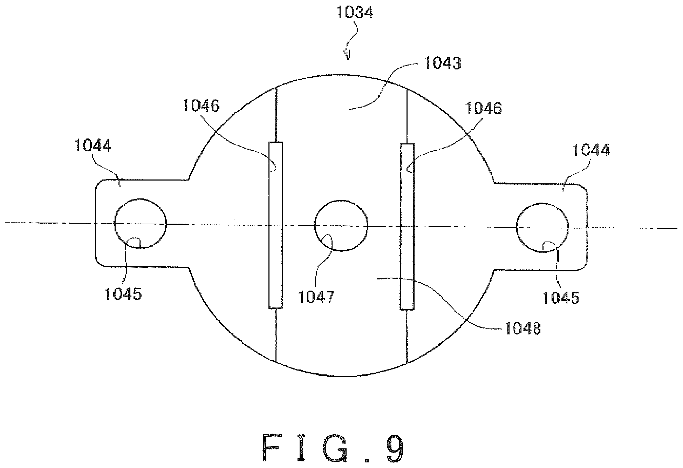

The following describes a configuration of an attraction unit 1030. Fig. 9 is a planar view schematically showing a flat spring 1034 of an attraction unit 1030.

The flat spring 1034 is an elastic member having elasticity in a direction orthogonal to the holding surface of the second substrate holder 1015 that holds the second substrate 1017, and may be formed of a high-strength precipitation-hardening stainless steel, such as SUS 631. The flat spring 1034 is formed by a central circular portion 1043 and attaching sections 1044 protruding therefrom as ears. The circular portion 1043 has a diameter of 22 mm and a thickness of 0.1 mm.

A pair of slits 1046 that extend in the same direction as each other are arranged in the circular portion 1043 with an interval therebetween in a direction orthogonal to the extension direction. Each slit 1046 is the same distance from the center of the circular portion 1043. The two slits 1046 form a band-shaped portion 1048 in the central region of the circular portion 1043. A through-hole 1047 that fixes the attracting element 1033 is formed in the band-shaped portion 1048 at the center of the circular portion 1043. Similarly, each attaching section 1044 includes a threaded hole 1045 through which passes a screw for fixing the flat spring 1034 to the second substrate holder 1015. The flat spring 1034 is arranged in a peripheral region of the holder body 1023, such that the two threaded holes 1045 are oriented along a circumferential direction of the second substrate holder 1015 and the extension direction of each slit 1046 is oriented along the radial direction of the second substrate holder 1015.

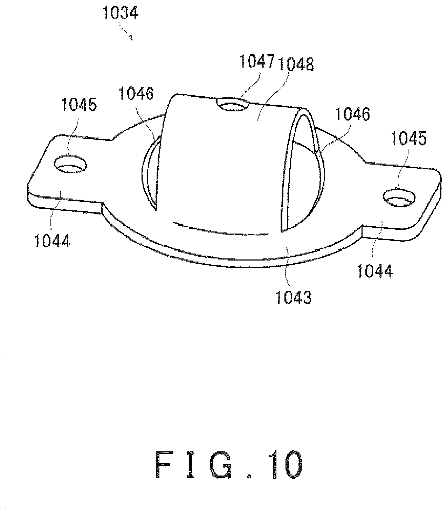

Fig. 10 is a perspective view schematically showing a state in which the flat spring 1034 is elastically deformed. Specifically, Fig. 10 shows a state in which the attracting element 1033 fixed to the flat spring 1034 is engaged with the magnet unit 1031 via attraction. It should be noted that the attracting element 1033 is not shown in Fig. 10.

In the flat spring 1034, as a result of the attracting element 1033 being attracted to the magnet unit 1031, the band-shaped portion 1048 rises upward such that that the through-hole 1047 becomes a peak, and the therefore two portions of the periphery of the circular portion 1043 connected to the band-shaped portion 1048 are deformed to draw closer to each other. At this time, the shapes of the openings in the slits 1046 are deformed to allow for the above deformation.

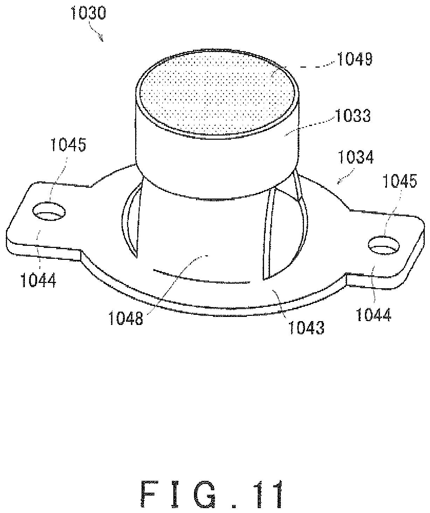

Fig. 11 is a perspective view including the attracting element 1033 when the flat spring 1034 of Fig. 10 is in the deformed state. The attracting element 1033 is fixed to the flat spring 1034 via the through-hole 1047, by a fastening member such as a screw.

The attracting element 1033 is formed of a ferromagnetic body, such as carbon steel S25C. A buffer plate 1049 is fixed to the contact surface of the attracting element 1033 that contacts the magnet unit 1031. The hardness of the buffer plate 1049 is less than that of the material forming the contact surface of the magnet unit 1031. For example, the material of the buffer plate may be a Si-type material or a resin material.

The buffer plate 1049 is preferably configured to be replaceable on the attracting element 1033. The buffer plate 1049 contacts the contact surface of the magnet unit 1031 and receives a focused stress, particularly when protruding portions such as the spherical protrusions 1041 or the linear protrusions 1050 are provided. Therefore, a depression or scraping can occur in the buffer plate 1049 as a result of the buffer plate 1049 absorbing the impact. Therefore, the buffer plate 1049 is replaced for every prescribed number of uses. The buffer plate 1049 is fixed by engaging with a recessed portion provided in the attracting element 1033 or by using an adhesive agent, for example.

In the above description, the support section 1035 of the magnet unit 1031 is provided with protruding portions such as the spherical protrusions 1041, and buffer plates 1049 are provided on the attracting element 1033 facing the protruding portions. However, the magnet unit 1031 and the attraction unit 1030, which are respectively the engaging member and the engagement receiving member, are in a relative relationship, and therefore the protruding portions and the buffer plates 1049 may each be formed on the opposite unit.

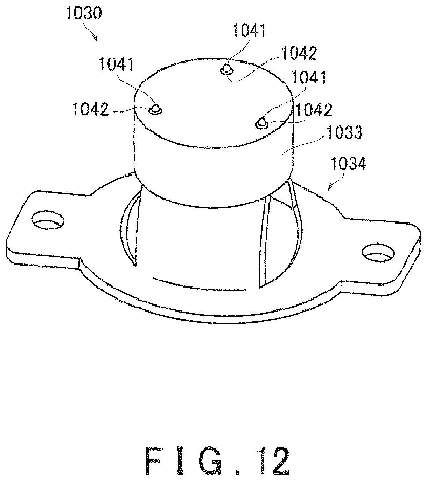

An example of this is provided in Fig. 12, which is a perspective view in which the spherical protrusions 1041 are arranged on the attracting element 1033. In the same manner as the example in which the spherical protrusions 1041 are provided on the support section 1035 of the magnet unit 1031, at least three spherical protrusions 1041 are embedded by being pressed in fixing members 1042, which are brass rings, for example. As another example, the spherical protrusions 1041 may be formed integrally with the attracting element 1033 by using machining such as polishing. With this configuration, the buffer plate 1049 is instead provided on the support section 1035 of the magnet unit 1031.

It should be noted that even if the positions of the protruding portions and the buffer plates 1049 are reversed, the contact surfaces of the attracting element 1 033 and the magnet unit 1031 in the gravitational direction are still positioned to be below the bonding surfaces of the second substrate 1017 and the first substrate 1016. The contact surfaces are preferably positioned below the first substrate 1016 holding surface of the first substrate holder 1014.

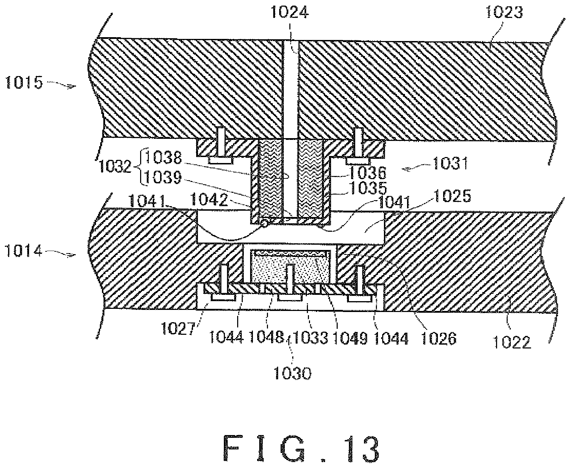

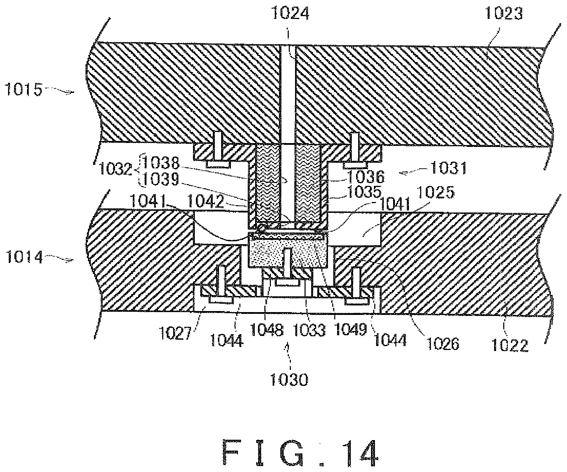

Fig. 13 is a cross-sectional view showing the coupling operation between the magnet unit 1031 and the attraction unit 1030. In particular, Fig. 13 shows a cross section over the line B-B in Figs. 3 and 4. The first substrate 1016, the second substrate 1017, the push pin 1054, etc. are omitted from the drawing. Fig. 13 shows a state before the attracting element 1033 engages with the magnet unit 1031. Fig. 14 shows a state after the attracting element 1033 has engaged with the magnet unit 1031, using the same cross-sectional view as Fig. 13.

As shown in the drawings, the magnet unit 1031 is fixed to the surface of the second substrate holder 1015 by a screw. The flat surface that contacts the buffer plate 1049, which is the contact surface of the attracting element 1033, is the virtual flat surface formed by the peaks of the spherical protrusions 1041. This virtual flat surface is positioned below the first substrate 1016 holding surface of the first substrate holder 1014.

In other words, the first substrate holder 1014 includes a recessed portion 1025 having a surface that is lower than the first substrate 1016 holding surface and corresponding to the region in which the attraction unit 1030 is provided. The virtual surface formed by the peaks of the spherical protrusions 1041 is positioned within the recessed portion 1025 when the surface of the first substrate 1016 contacts the surface of the second substrate 1017.

The recessed portion 1025 includes a through-hole 1026 that allows the attracting element 1033 to move up and down. The back surface of the first substrate holder 1014, which is the side opposite the surface holding the first substrate 1016, includes a recessed portion 1027 around the through-hole 1026, and the flat spring 1034 and a screw fixing the flat spring 1034 to the first substrate holder 1014 are arranged to be housed within the recessed portion.

As shown by the change from the state of Fig. 13 to the state of Fig. 14, the band-shaped portion 1048 to which the attracting element 1033 is affixed elastically deforms as a result of the attracting element 1033 being attracted by the magnet 1036. At this time, the attaching sections 1044 are fixed to the first substrate holder 1014, and therefore the flat spring 1034 biases the first substrate holder 1014 and the second substrate holder 1015 to draw closer to each other, by sandwiching the second substrate 1017 with the first substrate 1016.

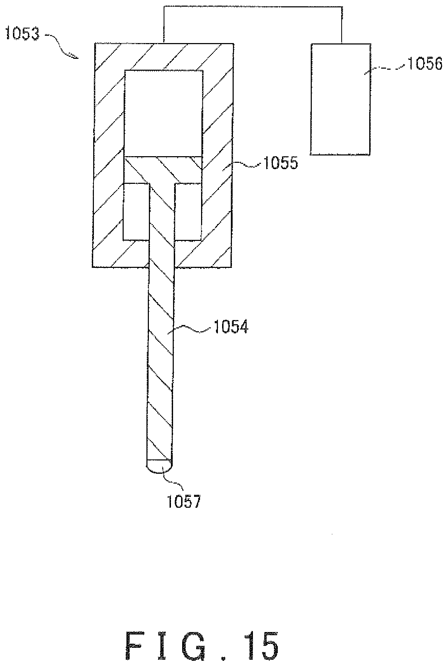

Fig. 15 is a cross-sectional view schematically showing the engagement control unit 1053. A plurality of engagement control units 1053 are arranged on the second substrate holder 1015, corresponding to the magnet units 1031. The cylinder portion 1055 is connected to an air pump 1056 that adjusts the atmospheric pressure within the cylinder portion 1055. The control section causes the push pin 1054 to extend and retract by controlling the air pump 1056. More specifically, the control section causes the push pin 1054 to be at the stored position in which at least a portion of the push pin 1054 is within the cylinder portion 1055 or at the extended position in which the tip 1057 of the push pin 1054 presses the buffer plate 1049. Accordingly, the pressing force exerted by the push pin 1054 on the buffer plate 1049 is large enough to resist the elastic force of the flat spring 1034.

The tip 1057 of the push pin 1054 is machined to be spherical, in order to achieve point contact with the buffer plate 1049. As another example, a tip portion such as a spherical protrusion 1041 may be provided as a separate member.

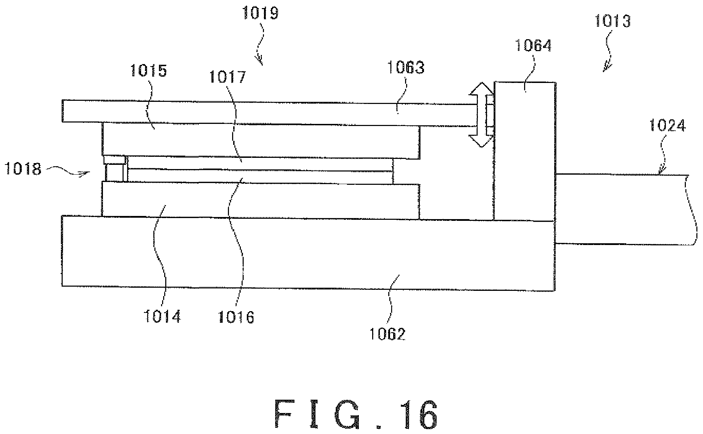

Fig. 16 is a side view schematically showing a state in which the transport apparatus 1013 grips the substrate holder pair 1018. The transport apparatus 1013 includes an arm portion 1020 and a gripping section 1019 that is connected to the arm portion 1020. The gripping section 1019 includes a support board 1062 that supports the substrate holder pair 1018 from below and a presser plate 1063 that presses the substrate holder pair 1018 from above. The support board 1062 includes a suction hole that fixes the substrate holder pair 1018 thereto using vacuum suction, and the substrate holder pair 1018 is fixed to the support board 1062 as a result of this suction.

The presser plate 1063 is provided on a support column 1064 formed on one end of the support board 1062, and can move back and forth in a direction to sandwich the substrate holder pair 1018. The presser plate 1063 exerts a pressing force on the substrate holder pair 1018 fixed to the support board 1062, such that the substrate holder pair 1018 can be sandwiched by the presser plate 1063 and the support board 1062. As a result of the arm portion 1020 moving while in this state, the transport apparatus 1013 transports the substrate holder pair 1018 from the alignment apparatus 1011 to the bonding apparatus 1012.

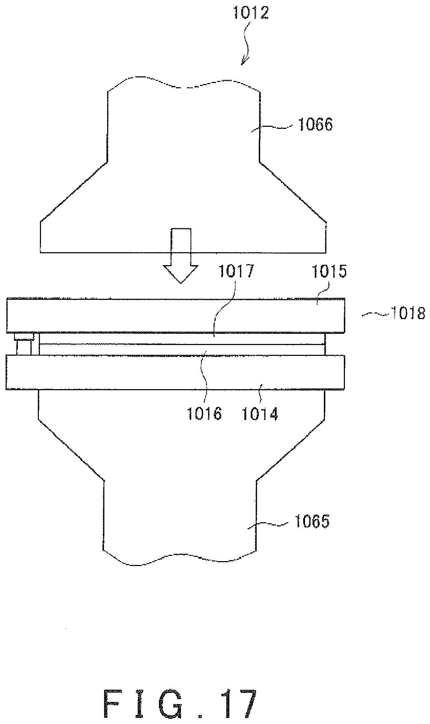

Fig. 17 is a side view schematically showing essential portions of the bonding apparatus 1012. The bonding apparatus 1012 includes a lower pressuring stage 1065 arranged below the first substrate holder 1014 and an upper pressuring stage 1066 arranged above the second substrate holder 1015. The upper pressuring stage 1066 can move toward the lower pressuring stage 1065, in order to apply pressure to the substrate holder pair 1018 together with the lower pressuring stage 1065. The lower pressuring stage 1065 and the upper pressuring stage 1066 each house a heater therein, and can therefore also apply heat to the substrate holder pair 1018 mounted thereon in addition to applying pressure. As a result of the pressure and heat being applied to the substrate holder pair 1018, the electrodes of the first substrate 1016 and the second substrate 1017 in contact with each other are fused together. As a result, the corresponding circuit regions 1021 of the first substrate 1016 and the second substrate 1017 are bonded together.

As described above, the contact surface area between the attracting element 1033 and the magnet unit 1031 is relatively small, so that dust does not enter therebetween. Accordingly, the dust attached to the contact surface of the attracting element 1033 or the magnet unit 1031 is restricted from being broken up, fragmented, and scattered during the bonding. When the fragmenting and scattering of dust is restricted, the dust is restricted from flowing toward the substrate. In particular, when the dust is fragmented and scattered, there is a problem that wind force occurring during the attachment or detachment of the first substrate 1016 and the second substrate 1017 when transporting the substrate holder pair 1018, for example, causes the fragmented dust to be lifted and spread easily. The present embodiment described above reduces the likelihood of this problem occurring. Furthermore, if the dust caught between substrates can be reduced, reduction in the contact surface between the attracting element 1033 and the magnet unit 1031 during bonding can be restricted. Accordingly, the present embodiment is also useful for preventing the occurrence of new dust.

### (Second Embodiment)

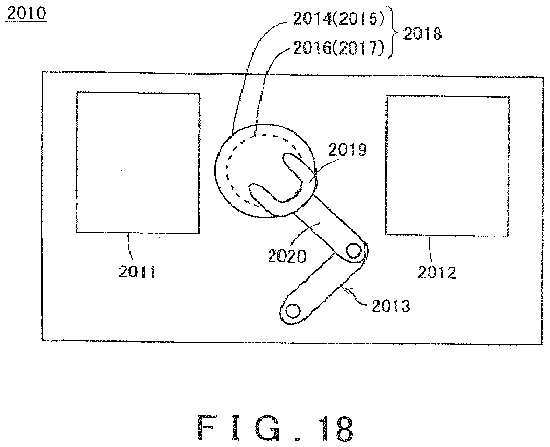

Fig. 18 schematically shows a substrate bonding apparatus 2010 according to a second embodiment. The substrate bonding apparatus 2010 includes an alignment apparatus 2011 that aligns a first substrate 2016, which is a semiconductor wafer, with a second substrate 2017, which is a semiconductor wafer to be layered on the first substrate 2016. The substrate bonding apparatus 2010 also includes a bonding apparatus 2012 that bonds together the first substrate 2016 and the second substrate 2017 aligned by the alignment apparatus 2011.

The first substrate 2016 is held by the first substrate holder 2014, and the second substrate 2017 is held by the second substrate holder 2015. In the alignment apparatus 2011, when the first substrate 2016 and the second substrate 2017 are aligned, the first substrate holder 2014 and the second substrate holder 2015 sandwich the first substrate 2016 and the second substrate 2017 to form these substrates integrally, thereby forming the substrate holder pair 2018. A detailed structure of the substrate holder pair 2018 is described further below.

The substrate bonding apparatus 2010 further includes a transport apparatus 2013 that transports the substrate holder pair 2018 integrated by the alignment apparatus 2011 to the bonding apparatus 2012. The transport apparatus 2013 can also transport a semiconductor wafer or a single substrate holder between apparatuses. The transport apparatus 2013 includes a gripping section 2019 that grips a gripping target such as the substrate holder pair 2018, and an arm portion 2020 that moves the gripping target to a prescribed position via rotating and extending/contracting movement.

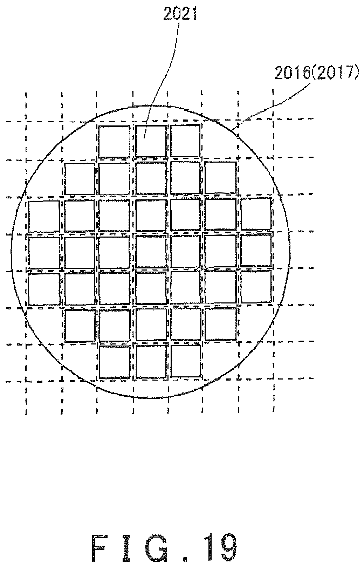

Fig. 19 is a planar view schematically showing a semiconductor wafer according to the present embodiment. The first substrate 2016 and the second substrate 2017, which are semiconductor wafers, are each formed of a circular thin board member made of single-crystal silicon, and each have one surface on which a plurality of circuit regions 2021 are formed. The circuit regions 2021 are partitioned into a matrix, and circuit elements such as transistors, resistors, and capacitors are formed therein. The circuit elements are formed using mainly lithography techniques such as thin film formation, etching, or impurity diffusion. Alignment marks are provided within each of the circuit regions 2021. The alignment marks are indicators used to align the substrates with each other. The plurality of alignment marks provided on each of the first substrate 2016 and the second substrate 2017 have their set coordinate values stored independently and managed in a memory. The semiconductor wafers to be layered may be semiconductor wafers that have already been layered with other semiconductor wafers. In this case, the previously layered circuit layers preferably undergo a thinning process to remove unnecessary thickness.

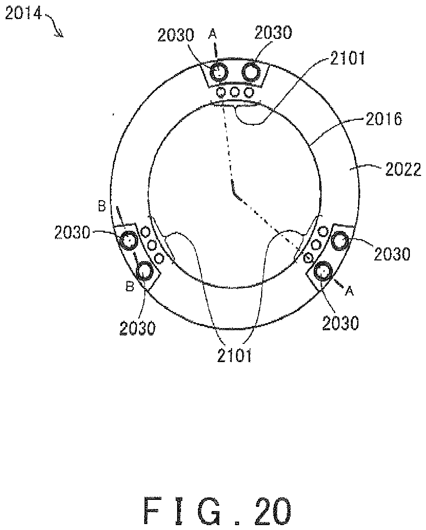

Fig. 20 is a planar view schematically showing the first substrate holder 2014 holding the first substrate 2016. The first substrate holder 2014 includes a holder body 2022 and an attraction unit 2030, which serves as an engaging section, and is shaped as a circular board with a diameter larger than that of the first substrate 2016. The holder body 2022 is formed integrally using a material with high rigidity such as ceramic or metal.

The holder body 2022 has a region for holding the first substrate 2016 on the surface thereof. This holding region is polished to be extremely flat. The holding of the first substrate 2016 is achieved by adhesion that uses electrostatic force. Specifically, voltage is applied to an electrode embedded in the holder body 2022, via a voltage application terminal provided on the back surface of the holder body 2022, to cause a potential difference between the first substrate holder 2014 and the first substrate 2016, thereby adhering the first substrate 2016 to the first substrate holder 2014. The adhesion surface of the first substrate 2016 is the surface opposite the surface on which the circuit regions 2021 are provided.

The attraction unit 2030 includes a plurality of peripheral regions, which are arranged further outward than the held first substrate 2016, on the surface thereof that holds the first substrate 2016. In the example shown in the drawings, sets that each include two attraction units 2030 are arranged at intervals of 120 degrees to obtain a total of six attraction units 2030. A more detailed configuration is described further below.

The first substrate holder 2014 includes first through-holes 2101 passing through the holder body 2022 in regions between the region holding the first substrate 2016 and the attraction units 2030. In the example of Fig. 20, three first through-holes 2101 are formed between each set of attraction units 2030 and the region holding the first substrate 2016, but the number of first through-holes 2101 provided may correspond to the number of attraction units 2030, and the first through-holes 2101 may be formed as elongated holes to correspond to the shape of the attraction unit 2030 sets.

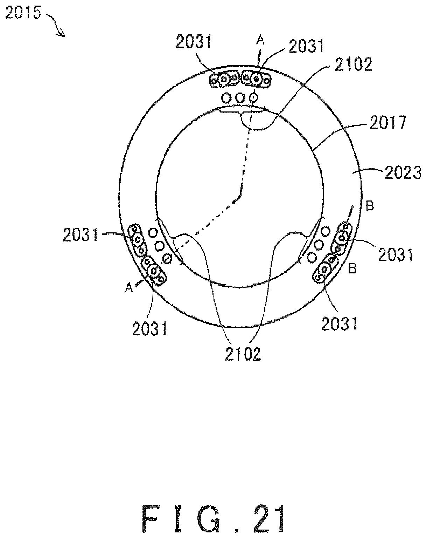

Fig. 21 is a planar view schematically showing the second substrate holder 2015 holding the second substrate 2017. The second substrate holder 2015 includes a holder body 2023 and magnet units 2031, which serve as engaging sections, and is shaped as a circular board with a diameter larger than that of the second substrate 2017. The holder body 2023 is formed integrally using a material with high rigidity such as ceramic or metal.

The holder body 2023 has a region for holding the second substrate 2017 on the surface thereof. This holding region is polished to be extremely flat. The holding of the second substrate 2017 is achieved by adhesion that uses electrostatic force. Specifically, voltage is applied to an electrode embedded in the holder body 2023, via a voltage application terminal provided on the back surface of the holder body 2023, to cause a potential difference between the second substrate holder 2015 and the second substrate 2017, thereby adhering the second substrate 2017 to the second substrate holder 2015. The adhesion surface of the second substrate 2017 is the surface opposite the surface on which the circuit regions 2021 are provided.

The magnet unit 2031 includes a plurality of peripheral regions, which are arranged further outward than the held second substrate 2017, on the surface thereof that holds the second substrate 2017. In the example shown in the drawings, sets that each include two magnet units 2031 are arranged at intervals of 120 degrees to obtain a total of six magnet units 2031.

The magnet units 2031 are arranged to correspond respectively to the attraction units 2030 of the first substrate holder 2014. When the first substrate holder 2014 holding the first substrate 2016 and the second substrate 2017 holding the second substrate holder 2015 face each other and the attraction units 2030 and magnet units 2031 are operated, the first substrate 2016 and the second substrate 2017 can be fixed together in a stacked state. This resulting stacked state is the substrate holder pair 2018. A more detailed configuration and the adhesion operation are described further below.

The second substrate holder 2015 includes second through-holes 2102 passing through the holder body 2023 in regions between the region holding the second substrate 2017 and the magnet units 2031. In the example of Fig. 21, three second through-holes 2102 are formed between each set of magnet units 2031 and a region holding the second substrate 2017, but the number of second through-holes 2102 provided may correspond to the number of magnet units 2031, and the second through-holes 2102 may be formed as elongated holes to correspond to the shape of the magnet unit 2031 sets. The first through-holes 2101 and the second through-holes 2102 form a dust flow inhibiting mechanism, and a detailed operation thereof is described further below.

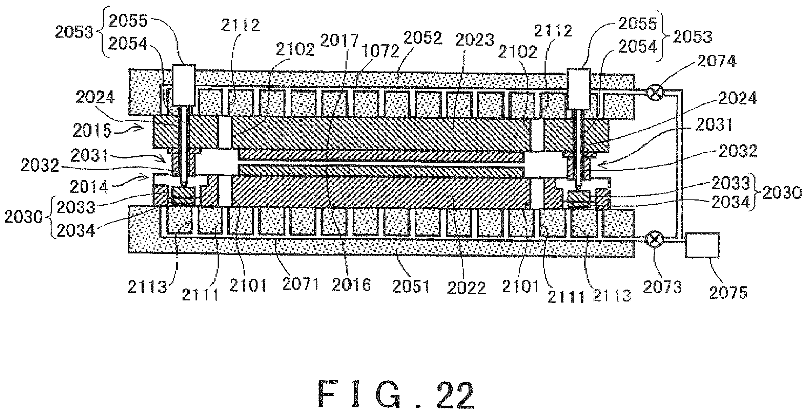

Fig. 22 is a cross-sectional view schematically showing a state immediately before the substrate holder pair 2018 is formed by the alignment apparatus 2011. Specifically, Fig. 22 is a cross-sectional view of a state in which the first substrate holder 2014 holding the first substrate 2016 is fixed to the first stage 2051 of the alignment apparatus 2011 by vacuum suction and the second substrate holder 2015 holding the second substrate 2017 is fixed to the second stage 2052 of the alignment apparatus 2011 by vacuum suction. In particular, the cross-sectional view is over the line A-A in Figs. 20 and 21.

The first substrate holder 2014 is fixed to the front surface of the first stage 2051 by a vacuum suction force exerted by a suction apparatus 2075 via a first suction piping 2071 passing through the first stage 2051 to reach the front surface thereof. The first suction piping 2071 includes a plurality of branches reaching the front surface of the first stage 2051, and exerts uniform suction over a wide region on the back surface of the first substrate holder 2014. The suction force of the suction apparatus 2075 is adjusted by a first valve 2073, in order to control attachment and detachment of the first substrate holder 2014.

Similarly, the second substrate holder 2015 is fixed to the front surface of the second stage 2052 by the vacuum suction force exerted by a suction apparatus 2075 via a second suction piping 2072 passing through the second stage 2052 to reach the front surface thereof. The second suction piping 2072 includes a plurality of branches reaching the front surface of the second stage 2052, and exerts uniform suction over a wide region on the back surface of the second substrate holder 2015. The suction force of the suction apparatus 2075 is adjusted by a second valve 2074, in order to control attachment and detachment of the second substrate holder 2015.

The first stage 2051 can move the first substrate 2016 relative to the second substrate 2017, in a Z-axis direction that is the layering direction and X-axis and Y-axis directions that are each orthogonal to the Z-axis. The alignment apparatus 2011 aligns the first substrate 2016 and the second substrate 2017, by using a first microscope arranged on the alignment apparatus 2011 in a manner to be able to observe the first substrate 2016 and a second microscope arranged on the alignment apparatus 2011 in a manner to be able to observe the second substrate 2017.

More specifically, each microscope is used to capture images of the alignment marks on each substrate serving as an observation target, and precise positions of the alignment marks are detected by performing image processing on the captured image data. The positional skew amount between corresponding alignment marks is then calculated and the first stage 2051 is moved according to this positional skew amount, thereby aligning the first substrate 2016 and the second substrate 2017. In this way, each circuit region 2021 of the first substrate 2016 faces a corresponding circuit region 2021 of the second substrate 2017. The positional skew amount calculation may be performed using a global alignment technique, for example, in which the positional skew amount is statistically determined to have a minimum value when the plurality of alignment marks of the first substrate 2016 overlap the plurality of alignment marks of the second substrate 2017.

When aligning the first substrate 2016 with the second substrate 2017, i.e. when moving the first stage 2051 in the XY-plane, a small gap is maintained between the first substrate 2016 and the second substrate 2017 such that the substrates do not contact each other. The second stage 2052 includes a plurality of engagement control units 2053, such that the attraction units 2030 do not engage with the magnet units 2031 when in this state.

Each engagement control unit 2053 is mainly formed from a push pin 2054, which is a member shaped as a pillar, and a cylinder portion 2055 that drives the push pin 2054. When at an extended position, the push pin 2054 passes through a holder insertion hole 2024 that is provided in the second substrate holder 2015 and a magnet insertion hole 2032 provided in the magnet unit 2031 arranged to be aligned with the holder insertion hole 2024, such that the tip of the push pin 2054 protrudes beyond the magnet insertion hole 2032. When at a storage position, a portion of the push pin 2054 is stored within the cylinder portion 2055, and is withdrawn from the insertion holes. In other words, the push pin 2054 moves back and forth in the Z-axis direction within the insertion holes, according to the drive of the cylinder portion 2055.

When the first substrate 2016 and the second substrate 2017 are to be moved relative to each other in the XY-plane, such as shown in Fig. 22, the push pins 2054 are held at the extended position in contact with the top surfaces of the attraction units 2030, thereby preventing the attraction units 2030 from engaging with the magnet units 2031. In other words, the attraction units 2030 are formed by attracting elements 2033 and flat springs 2034 fixed to the attracting elements 2033, but the push pins 2054 press on the attracting elements 2033 from above to restrict the elastic deformation of the flat springs 2034, such that the attracting elements 2033 do not engage with the magnet units 2031 as a result of the elastic deformation of the flat springs 2034.

The alignment of the first substrate 2016 and the second substrate 2017 by the alignment apparatus 2011 is performed at a final fine adjustment stage in which the movement amount is such that the tips of the push pins 2054 slide along the top surfaces of the attraction units 2030. At other stages, such as an observation stage in which the alignment marks are observed by the microscopes, the first substrate 2016 and the second substrate 2017 are separated from each other by a large amount in the X-, Y-, and Z-axis directions, and therefore the attraction units 2030 do not unexpectedly engage with the magnet units 2031. Accordingly, the push pins 2054 are held at the extended position when the magnetic force of the magnet units 2031 is exerted on the attraction units 2030 and engaging therebetween is to be prevented, and are held at the stored position at all other times.

A portion of the tubes branching from the first suction piping 2071 and connected to the front surface of the first stage 2051 are connected as first communicating tubes 2111 to the first through-hole 2101 of the first substrate holder 2014 fixed to the first stage 2051. A portion of the tubes branching from the second suction piping 2072 and connected to the front surface of the second stage 2052 are connected as second communicating tubes 2112 to the second through-hole 2102 of the second substrate holder 2015 fixed to the second stage 2052. Another portion of the tubes branching from the first suction piping 2071 and connected to the front surface of the first stage 2051 are connected as third communicating tubes 2113 to an empty space on the back surface side of the flat spring 2034 of the first substrate holder 2014 fixed to the first stage 2051.

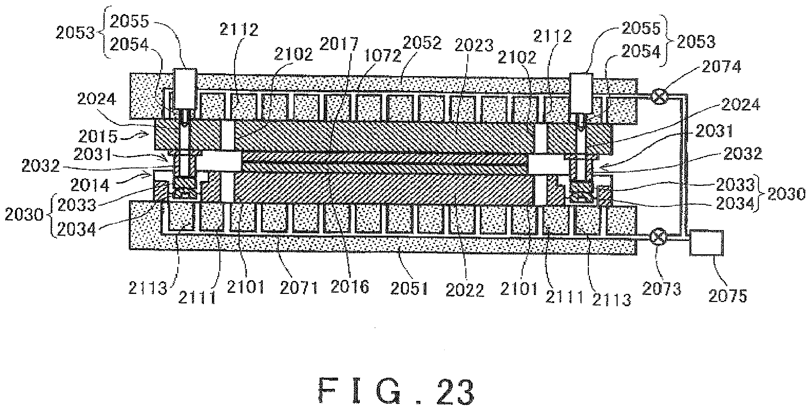

Fig. 23 is a cross-sectional view schematically showing a state immediately after formation of the substrate holder pair 2018 by the alignment apparatus 2011. Specifically, Fig. 23 shows a state in which the first stage 2051 has been driven in the Z-axis direction from the state shown in Fig. 22, such that the surface of the first substrate 2016 contacts the surface of the second substrate 2017, the push pins 2054 are held at the storage position, and the attraction units 2030 and magnet units 2031 are engaged.

During the process of transitioning from the state of Fig. 22 to the state of Fig. 23, the first substrate 2016 and the second substrate 2017 are aligned, and the magnet units 2031, which are engaging members, are engaged with the attraction units 2030, which are engagement receiving members. The first substrate holder 2014 and the second substrate holder 2015 are then formed integrally, thereby forming the substrate holder pair 2018 as the substrate holder system.

The Z-axis direction is the direction of gravitational force in the alignment apparatus 2011, and the first stage 2051 is positioned below the second stage 2052. Therefore, each surface is arranged from top to bottom, in the direction of the gravitational force, in the order of the second substrate 2017 holding surface of the second substrate holder 2015, the bonding surfaces of the second substrate 2017 and the first substrate 2016, and the first substrate 2016 holding surface of the first substrate holder 2014.

During the process of transitioning from the state of Fig. 22 to the state of Fig. 23, the movement of the push pins 2054 to the storage position causes elastic deformation of the flat springs 2034, and so the attraction units 2030 engage with the magnet units 2031. At this time, the engagement of the attracting elements 2033 of the attraction units 2030 with the magnet units 2031 is accompanied by a small impact. Therefore, at this time, the contact surfaces of the attracting elements 2033 and the magnet units 2031 in the gravitational force direction are set to be lower than the contact surfaces of the second substrate 2017 and the first substrate 2016. The contact surfaces of the attracting elements 2033 and the magnet units 2031 are preferably set to be lower than the first substrate 2016 holding surface of the first substrate holder 2014.

By setting such a positional relationship, even if dust is created and scattered by the impact of the engagement between the attraction units 2030 and the magnet units 2031, the dust can be expected to be pulled down by gravity and to not enter between the first substrate 2016 and the second substrate 2017. Even if some dust moves from the space between the first substrate holder 2014 and the second substrate holder 2015 toward the first substrate 2016 and the second substrate 2017, this dust can be expected to be withdrawn from the first through-holes 2101 and the second through-holes 2102.

Specifically, the first through-holes 2101 connected to the first communicating tubes 2111 and the second through-holes 2102 connected to the second communicating tubes 2112 exert suction due to the operation of the suction apparatus 2075, and suck in the atmosphere near the openings thereof. When some of the dust generated by the impact of the bonding between the attraction unit 2030 and the magnet unit 2031 passes near the opening of the first through-holes 2101 and the second through-holes 2102, the this dust is sucked into the openings along with the nearby atmosphere and withdrawn into the first suction piping 2071 or the second suction piping 2072. In other words, the generated dust can be expected to be withdrawn before entering between the first substrate 2016 and the second substrate 2017. Dust entering between the substrates causes problems in the circuit operation and insufficient bonding strength, but these problems can be ameliorated by adopting the configuration described above.

Furthermore, the third communicating tubes 2113 are connected to an empty space on the back surface side of the flat spring 2034, and therefore the dust generated by the impact of the bonding between the attraction unit 2030 and the magnet unit 2031 can also be expected to be withdrawn by the third communicating tubes 2113. In other words, the third communicating tubes 2113 also exert suction due to the operation of the suction apparatus 2075 to suck in atmosphere from the empty space on the back surface side of the flat spring 2034, and therefore the generated dust is withdrawn to the first suction piping 2071 along with the suctioned atmosphere.

The suction force of the first suction piping 2071 and the second suction piping 2072 may be strengthened during a prescribed period beginning when the attraction unit 2030 and the magnet unit 2031 are engaged, by adjusting the first valve 2073 and the second valve 2074. By strengthening the suction force in this way, the dust can be withdrawn more reliably.

After the substrate holder pair 2018 is formed, the substrate holder pair 2018 is released from the vacuum suction of the second stage 2052, lifted up by the first stage 2051, and transported to the bonding apparatus 2012 by the transport apparatus 2013. The transportation mechanism of the transport apparatus 2013 and the bonding process of the bonding apparatus 2012 are described further below.

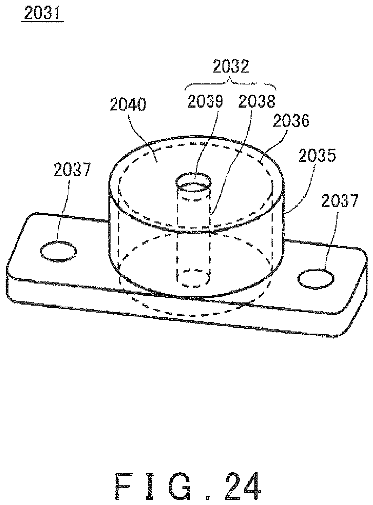

The following describes a configuration of the magnet unit 2031. Fig. 24 is a perspective view schematically showing the magnet unit 2031. The magnet unit 2031 includes a magnet 2036 and a support section 2035 housing the magnet 2036.

The support section 2035 includes a housing portion shaped as a circular cylinder that houses the magnet 2036, and a threaded hole 2037 through which passes a screw for fixing the support section 2035 to second substrate holder 2015. The support section 2035 is formed by carbon steel S25C, for example. The support section 2035 has a counterface surface 2040 facing the attracting element 2033. The magnet 2036 is a permanent magnet shaped as a circular pillar that can be inserted into the housing portion of the support section 2035, and may have a magnetic force of approximately 8 N, for example. The central axis of the magnet 2036 is provided with an insertion hole 2038 into which is inserted a push pin 2054, and an insertion hole 2039 in series with the insertion hole 2038 and into which the support section 2035 is inserted. The magnet insertion hole 2032 is formed by these two insertion holes.

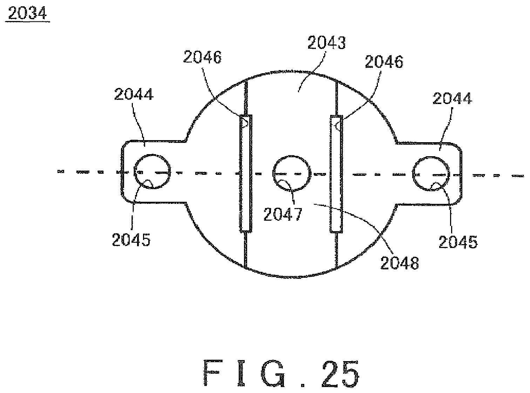

The following describes a configuration of an attraction unit 2030. Fig. 25 is a planar view schematically showing a flat spring 2034 of an attraction unit 2030. The flat spring 2034 is an elastic member having elasticity in a direction orthogonal to the holding surface of the second substrate holder 2015 that holds the second substrate 2017, and may be formed of a high-strength precipitation-hardening stainless steel, such as SUS 631. The flat spring 2034 is formed by a central circular portion 2043 and attaching sections 2044 protruding therefrom as ears. The circular portion 2043 has a diameter of 22 mm and a thickness of 0.1 mm.

A pair of slits 2046 that extend in the same direction as each other are arranged in the circular portion 2043 with an interval therebetween in a direction orthogonal to the extension direction. Each slit 2046 is the same distance from the center of the circular portion 2043. The two slits 2046 form a band-shaped portion 2048 in the central region of the circular portion 2043. A through-hole 2047 that fixes the attracting element 2033 is formed in the band-shaped portion 2048 at the center of the circular portion 2043. Similarly, each attaching section 2044 includes a threaded hole 2045 through which passes a screw for fixing the flat spring 2034 to the second substrate holder 2015. The flat spring 2034 is arranged in a peripheral region of the holder body 2023, such that the two threaded holes 2045 are oriented along a circumferential direction of the second substrate holder 2015 and the extension direction of each slit 2046 is oriented along the radial direction of the second substrate holder 2015.

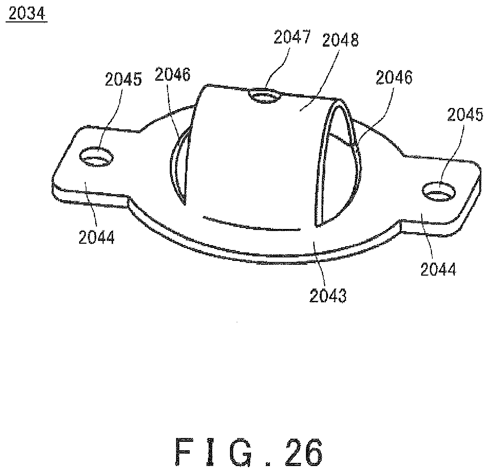

Fig. 26 is a perspective view schematically showing a state in which the flat spring 2034 is elastically deformed. Specifically, Fig. 10 shows a state in which the attracting element 2033 fixed to the flat spring 2034 is engaged with the magnet unit 2031 via attraction. It should be noted that the attracting element 2033 is not shown in Fig. 26.

In the flat spring 2034, as a result of the attracting element 2033 being attracted to the magnet unit 2031, the band-shaped portion 2048 rises upward such that that the through-hole 2047 becomes a peak, and the therefore two portions of the periphery of the circular portion 2043 connected to the band-shaped portion 2048 are deformed to draw closer to each other. At this time, the shapes of the openings in the slits 2046 are deformed to allow for the above deformation.

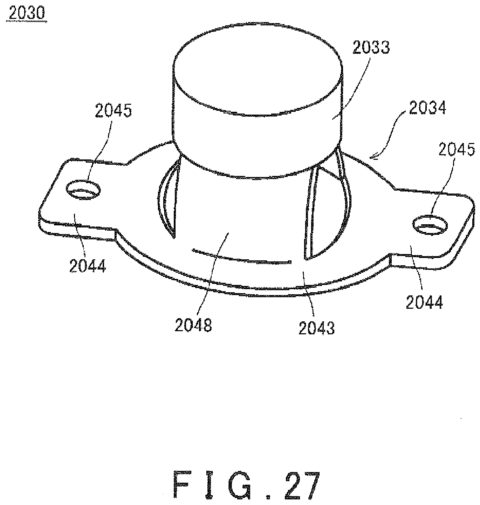

Fig. 27 is a perspective view including the attracting element 2033 when the flat spring 2034 of Fig. 26 is in the deformed state. The attracting element 2033 is fixed to the flat spring 2034 via the through-hole 2047, by a fastening member such as a screw. The attracting element 2033 is formed of a ferroelectric body. For example, the attracting element 2033 may be formed of carbon steel S25C.

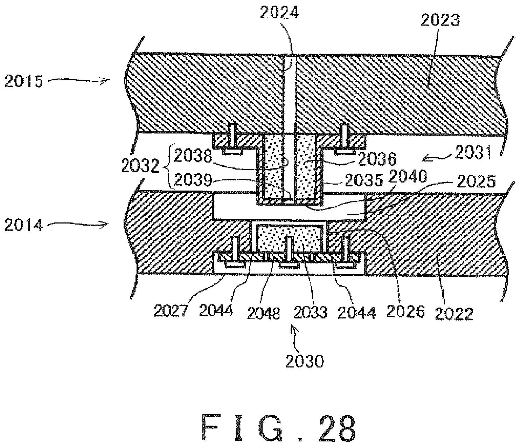

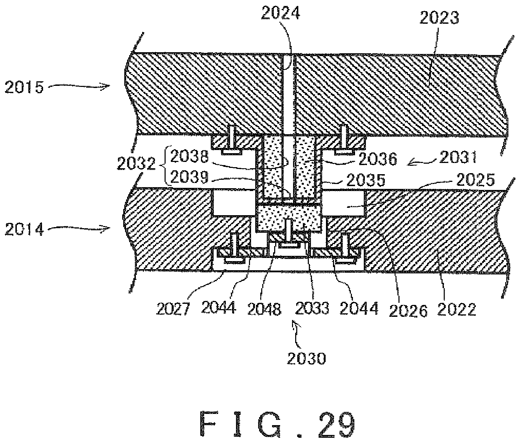

Fig. 28 is a cross-sectional view showing the coupling operation between the magnet unit 2031 and the attraction unit 2030. In particular, Fig. 28 shows a cross section over the line B-B in Figs. 20 and 21. The first substrate 2016, the second substrate 2017, the push pin 2054, etc. are omitted from the drawing. Fig. 28 shows a state before the attracting element 2033 engages with the magnet unit 2031. Fig. 29 shows a state after the attracting element 2033 has engaged with the magnet unit 2031, using the same cross-sectional view as Fig. 28.

As shown in the drawings, the magnet unit 2031 is fixed to the surface of the second substrate holder 2015 by a screw. The counterface surface 2040 facing the attracting element 2033 is positioned below the first substrate 2016 holding surface of the first substrate holder 2014. In other words, the first substrate holder 2014 includes a recessed portion 2025 having a surface that is lower than the first substrate 2016 holding surface and corresponding to the region in which the attraction unit 2030 is provided. Specifically, the counterface surface 2040, which is the expected contact surface of the magnet unit 2031 expected to contact the attracting element 2033, is positioned within the recessed portion 2025 when the front surface of the first substrate 2016 and the front surface of the second substrate 2017 are in contact.

The recessed portion 2025 includes a through-hole 2026 that allows the attracting element 2033 to move up and down. The back surface of the first substrate holder 2014, which is the side opposite the surface holding the first substrate 2016, includes a recessed portion 2027 around the through-hole 2026, and the flat spring 2034 and a screw fixing the flat spring 2034 to the first substrate holder 2014 are arranged to be housed within the recessed portion.

As shown by the change from the state of Fig. 28 to the state of Fig. 29, the band-shaped portion 2048 to which the attracting element 2033 is affixed elastically deforms as a result of the attracting element 2033 being attracted by the magnet 2036. At this time, the attaching sections 2044 are fixed to the first substrate holder 2014, and therefore the flat spring 2034 biases the first substrate holder 2014 and the second substrate holder 2015 to draw closer to each other, by sandwiching the second substrate 2017 with the first substrate 2016.

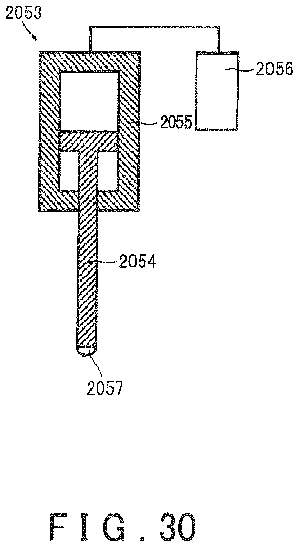

Fig. 30 is a vertical cross-sectional view schematically showing the engagement control unit 2053. A plurality of engagement control units 2053 are arranged on the second substrate holder 2015, corresponding to the magnet units 2031. The cylinder portion 2055 is connected to an air pump 2056 that adjusts the atmospheric pressure within the cylinder portion 2055. The control section causes the push pin 2054 to extend and retract by controlling the air pump 2056. More specifically, the control section causes the push pin 2054 to be at the stored position in which at least a portion of the push pin 2054 is within the cylinder portion 2055 or at the extended position in which the tip 2057 of the push pin 2054 presses the attracting element 2033. Accordingly, the pressing force exerted by the push pin 2054 on the attracting element 2033 is large enough to resist the elastic force of the flat spring 2034. The tip 2057 of the push pin 2054 is machined to be spherical, so as to achieve point contact with the attracting element 2033.

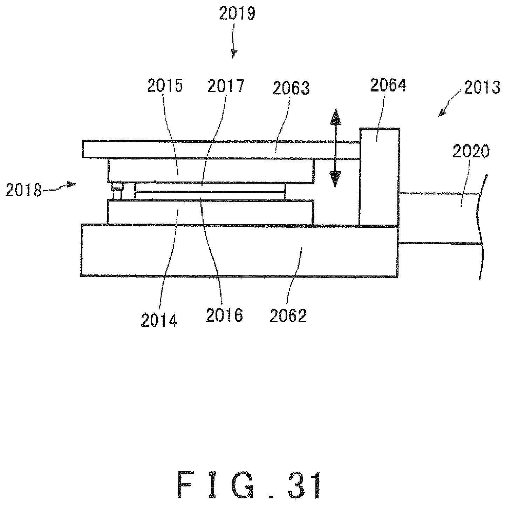

Fig. 31 is a side view schematically showing a state in which the transport apparatus 2013 grips the substrate holder pair 2018. The transport apparatus 2013 includes an arm portion 2020 and a gripping section 2019 that is connected to the arm portion 2020. The gripping section 2019 includes a support board 2062 that supports the substrate holder pair 2018 from below and a presser plate 2063 that presses the substrate holder pair 2018 from above. The support board 2062 includes a suction hole that fixes the substrate holder pair 2018 thereto using vacuum suction, and the substrate holder pair 2018 is fixed to the support board 2062 as a result of this suction.

The presser plate 2063 is provided on a support column 2064 formed on one end of the support board 2062, and can move back and forth in a direction to sandwich the substrate holder pair 2018. The presser plate 2063 exerts a pressing force on the substrate holder pair 2018 fixed to the support board 2062, such that the substrate holder pair 2018 can be sandwiched by the presser plate 2063 and the support board 2062. As a result of the arm portion 2020 moving while in this state, the transport apparatus 2013 transports the substrate holder pair 2018 from the alignment apparatus 2011 to the bonding apparatus 2012.

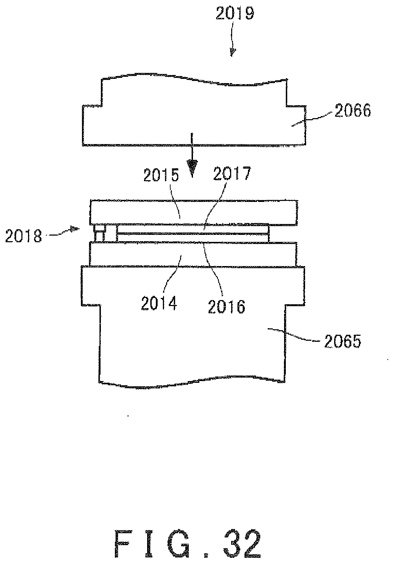

Fig. 32 is a side view schematically showing essential portions of the bonding apparatus 2012. The bonding apparatus 2012 includes a lower pressuring stage 2065 arranged below the first substrate holder 2014 and an upper pressuring stage 2066 arranged above the second substrate holder 2015. The upper pressuring stage 2066 can move toward the lower pressuring stage 2065, in order to apply pressure to the substrate holder pair 2018 together with the lower pressuring stage 2065. The lower pressuring stage 2065 and the upper pressuring stage 2066 each house a heater therein, and can therefore also apply heat to the substrate holder pair 2018 mounted thereon in addition to applying pressure. As a result of the pressure and heat being applied to the substrate holder pair 2018, the electrodes of the first substrate 2016 and the second substrate 2017 in contact with each other are fused together. As a result, the corresponding circuit regions 2021 of the first substrate 2016 and the second substrate 2017 are bonded together.

### (First Modification of Second Embodiment)

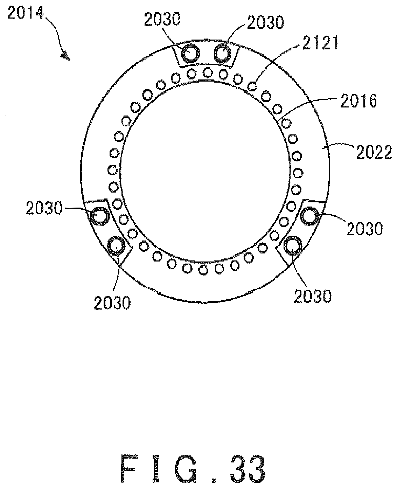

Fig. 33 is a planar view schematically showing a first substrate holder 2014 including a dust flow inhibiting mechanism, as a first modification of the second embodiment. The first substrate holder 2014 described in Fig. 20 includes first through-holes 2101 passing through the holder body 2022 in regions between the region holding the first substrate 2016 and the attraction units 2030. In contrast to this, the present modification includes, in addition to the first through-holes 2101, a plurality of through-holes that surround the region for holding the first substrate 2016. All of the through-holes together form an annular through-hole 2121 on the holder body 2022.

A plurality of through-holes corresponding to the annular through-hole 2121 of the first substrate holder 2014 are formed in a ring on the second substrate holder 2015. These through-holes are respectively connected to corresponding communicating tubes when the first stage 2051 or the second stage 2052 is exerting suction, in the same manner as the first communicating tubes 2111 connected to the first through-holes 2101 and the second communicating tubes 2112 connected to the second through-holes 2102. The through-holes connected to the communicating tubes suck in atmosphere near the openings thereof, as a result of the operation of the suction apparatus 2075. The substrate holder pair 2018 with this configuration can be expected to withdraw not only the dust generated by the bonding impact between the attraction unit 2030 and the magnet unit 2031, but also the dust that is scattered in the surrounding atmosphere, thereby preventing dust from entering between the first substrate 2016 and the second substrate 2017.

In the embodiment described above, suction is achieved through the through-holes by using communicating tubes that branch from the first suction piping 2071 or the second suction piping 2072. However, the at least one of the communicating tubes connected to a through-hole of the first substrate holder 2014 or the second substrate holder may be provided as a system that is separate from the first suction piping 2071 and the second suction piping 2072. If control is performed such that one intakes atmosphere while the other ejects atmosphere, an air curtain can be formed around the region for holding the substrate, and therefore dust from outside this region can be expected to be prevented from entering into this region.

### (Second Modification of Second Embodiment)

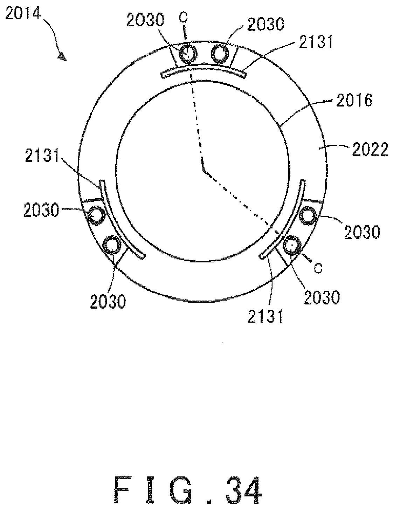

Fig. 34 is a planar view schematically showing a first substrate holder 2014 including a dust flow inhibiting mechanism, as a second modification of the second embodiment. The first substrate holder 2014 described in Fig. 20 includes first through-holes 2101 passing through the holder body 2022 in regions between the region holding the first substrate 2016 and the attraction units 2030. In contrast to this, the present modification includes, instead of the first through-holes 2101, first dust blocking walls 2131 formed by protrusions from the first substrate 2016 holding surface. In the example of Fig. 34, three arc-shaped first dust blocking walls 2131 are provided corresponding to the sets of attraction units 2030. The central angle of these arcs is set to be greater that the central angle formed by a set of attraction units 2030 in the circumferential direction.

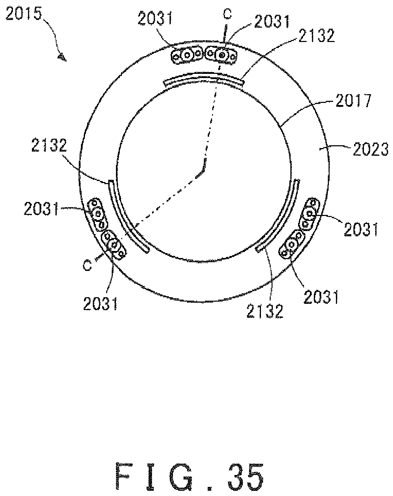

Fig. 35 is a planar view schematically showing a second substrate holder 2015 including a dust flow inhibiting mechanism according to the second modification. The second substrate holder 2015 described in Fig. 21 includes second through-holes 2102 passing through the holder body 2023 in regions between the region holding the second substrate 2017 and the magnet units 2031. In contrast to this, the present modification includes, instead of the second through-holes 2102, second dust blocking walls 2132 formed by protrusions from the second substrate 2017 holding surface. In the example of Fig. 35, three arc-shaped second dust blocking walls 2132 are provided corresponding to the sets of magnet units 2031. The central angle of these arcs is set to be greater that the central angle formed by a set of magnet units 2031 in the circumferential direction.

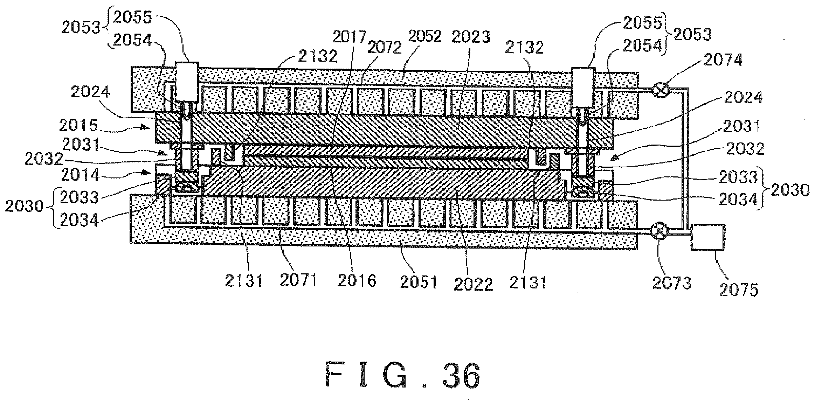

Fig. 36 is a cross-sectional view schematically showing a state immediately after formation of the substrate holder pair 2018 according to the second modification. Specifically, Fig. 36 is a cross-sectional view of a state in which the first substrate holder 2014 holding the first substrate 2016 is fixed to the first stage 2051 of the alignment apparatus 2011 by vacuum suction and the second substrate holder 2015 holding the second substrate 2017 is fixed to the second stage 2052 of the alignment apparatus 2011 by vacuum suction. In particular, the cross-sectional view is over the line C-C in Figs. 34 and 35.

As shown in the drawings, the first dust blocking walls 2131 and the second dust blocking walls 2132 are in a nested form when the first substrate holder 2014 and the second substrate holder 2015 are stacked. The height of each first dust blocking wall 2131 is such that, when the first substrate holder 2014 and the second substrate holder 2015 are stacked, the first dust blocking wall 2131 extends beyond the contact surfaces of the first substrate 2016 and the second substrate 2017 toward the second substrate holder 2015 but does not contact the holding surface of the second substrate holder 2015 holding the second substrate 2017. The height of each second dust blocking wall 2132 is such that, when the first substrate holder 2014 and the second substrate holder 2015 are stacked, the second dust blocking wall 2132 extends beyond the contact surfaces of the first substrate 2016 and the second substrate 2017 toward the first substrate holder 2014 but does not contact the holding surface of the first substrate holder 2014 holding the first substrate 2016. Furthermore, the first dust blocking walls 2131 are formed further outward in a radial direction than the second dust blocking walls 2132, for example, such that the dust blocking walls do not interfere with each other. The inward or outward relationship in the radial direction may be reversed, and may be changed for each combination of an attraction unit 2030 and a magnet unit 2031.

With this configuration, even if dust is generated and scattered by the bonding impact between the attraction unit 2030 and the magnet unit 2031, the dust does not directly move toward the first substrate 2016 and the second substrate 2017. Specifically, the scattered dust can be expected to be prevented from passing beyond the first dust blocking walls 2131 and the second dust blocking walls 2132 prior to reaching the first substrate 2016 or the second substrate 2017, and therefore the dust does not stick to the first substrate 2016 or the second substrate 2017.

If the contact surfaces of the attraction unit 2030 and the magnet unit 2031 are positioned below the first substrate 2016 holding surface of the first substrate holder 2014 in the direction of gravity, the first dust blocking walls 2131 are preferably provided further outward than the second dust blocking walls 2132 in the radial direction. As a result, a path can be formed that makes it difficult for the dust to move toward the first substrate 2016 and the second substrate 2017.

The first dust blocking walls 2131 and the second dust blocking walls 2132 are not limited to having the arc shape described above. For example, each first dust blocking wall 2131 may include a radially shaped portion in addition to the arc shape, in a manner to surround the corresponding attraction unit 2030 group. In order to correspond to this shape, the second dust blocking walls 2132 may also each include a radially shaped portion in addition to the arc shape, in a manner to surround the corresponding magnet unit 2031 group. As another example, the first dust blocking wall 2131 may have a circular shape that surrounds the perimeter of the region for holding the first substrate 2016. In order to correspond to this shape, the second dust blocking wall 2132 may also have a circular shape that surrounds the perimeter of the region for holding the second substrate 2017. With the above shapes as well, dust generated by the bonding impact between the attraction unit 2030 and the magnet unit 2031 can be made to travel a complex path in order to each the first substrate 2016 and the second substrate 2017, in the same manner as when an arc shaped is used, and therefore the dust-blocking effect can be expected.

### (Third Modification of Second Embodiment)

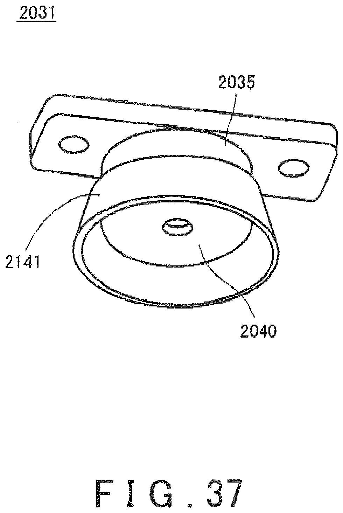

Fig. 37 is a perspective view schematically showing a magnet unit 2031 including a dust flow inhibiting mechanism, as a third modification of the second embodiment. The magnet unit according to the present modification further includes a shield 2141 in addition to the magnet unit 2031 described in Fig. 24. The shield 2141 is affixed by coupling with an outer cylindrical surface of the support section 2035, and is formed as a skirt that covers the counterface surface 2040 in a radial direction.

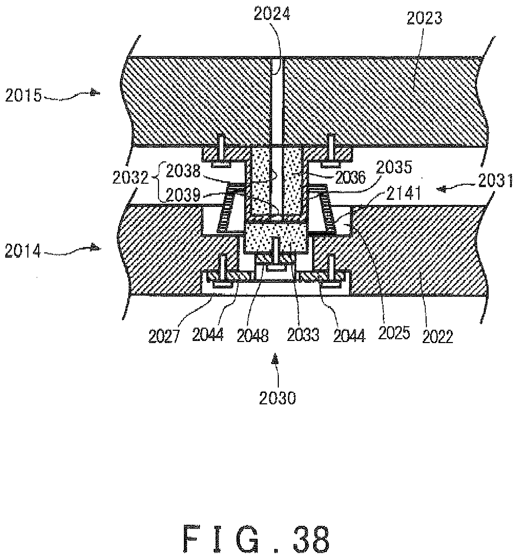

Fig. 38 is a cross-sectional view of a state in which the magnet unit 2031 with the shield 2141 attached thereto contacts the attraction unit 2030. The contact surfaces of the attraction unit 2030 and the magnet unit 2031 are positioned below the first substrate 2016 holding surface of the first substrate holder 2014, in the direction of gravity. Accordingly, when the first substrate holder 2014 and the second substrate holder 2015 are stacked, the recessed portion 2025 allows the shield 2141 to move below the first substrate 2016 holding surface of the first substrate holder 2014.

The magnet unit 2031 including the shield 2141 can trap the dust generated by the bonding impact of the attraction unit 2030 and the magnet unit 2031, within the shield 2141. Accordingly, the amount of dust expected to reach the first substrate 2016 and the second substrate 2017 is extremely small.

The shield 2141 may be freely attachable to the magnet unit 2031. In this case, maintenance can be performed easily by exchanging a shield 2141 that has become dirty due to the dust therein. As another example, the shield 2141 may be formed integrally with the support section 2035. In this case, the number of components is decreased, allowing for easier assembly.

In the manner described above, an electrode is embedded in the holder body 2023 of the second substrate holder 2015 to generate a potential difference between the second substrate holder 2015 and the second substrate 2017, thereby adhering the second substrate 2017 to the second substrate holder 2015. A charging section connected to the electrode may be provided on the shield 2141 to charge the shield 2141. When the shield 2141 is charged, the dust is expected to be attracted to the shield 2141, thereby increasing the dust trapping efficiency.

In the above modification, the shield is provided for the magnet unit 2031. However, the shield 2141 may instead be attached to the attracting element 2033. With this configuration as well, the scattering of the dust generated by the bonding impact between the attraction unit 2030 and the magnet unit 2031 can be restricted.

As described above, in each of the embodiments, the flow of dust toward the mounting regions for the first substrate 2016 and the second substrate 2017 can be inhibited when the attraction unit 2030 is engaged with the magnet unit 2031 in the substrate holder pair 2018. In other words, the flow of dust generated from both the attraction unit 2030 and the magnet unit 2031 due to the impact when these units are engaged can be inhibited. Furthermore, when the substrate holder pair 2018 is transported after the bonding, the flow dust between the first substrate holder 2014 and the second substrate holder 2015 toward the mounting regions of the first substrate 2016 and the second substrate 2017 is expected to be inhibited. Accordingly, circuit malfunctions due to dust in a device manufactured using the substrate holder pair 2018 are restricted, and therefore the device can be expected to have high quality. Furthermore, a high yield can be expected for the manufacturing of the device.

### (Third Embodiment)

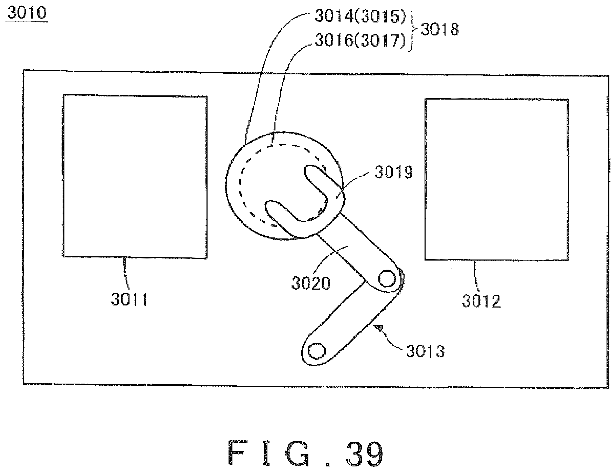

Fig. 39 schematically shows a substrate bonding apparatus 3010 according to a third embodiment. The substrate bonding apparatus 3010 includes an alignment apparatus 3011 that aligns a first substrate 3016, which is a semiconductor wafer, with a second substrate 3017, which is a semiconductor wafer to be layered on the first substrate 3016. The substrate bonding apparatus 3010 also includes a bonding apparatus 3012 that bonds together the first substrate 3016 and the second substrate 3017 aligned by the alignment apparatus 3011. The bonding apparatus 3012 performs permanent bonding of the first substrate 3016 and the second substrate 3017 by applying pressure or both pressure and heat thereto.

The first substrate 3016 is held by the first substrate holder 3014, and the second substrate 3017 is held by the second substrate holder 3015. In the alignment apparatus 3011, when the first substrate 3016 and the second substrate 3017 are aligned, the first substrate holder 3014 and the second substrate holder 3015 sandwich the first substrate 3016 and the second substrate 3017 to form these substrates integrally, thereby forming the substrate holder pair 3018. A detailed structure of the substrate holder pair 3018 is described further below.

The substrate bonding apparatus 3010 further includes a transport apparatus 3013 that transports the substrate holder pair 3018 integrated by the alignment apparatus 3011 to the bonding apparatus 3012. The transport apparatus 3013 can also transport a semiconductor wafer or a single substrate holder between apparatuses. The transport apparatus 3013 includes a gripping section 3019 that grips a gripping target such as the substrate holder pair 3018, and an arm portion 3020 that moves the gripping target to a prescribed position via rotating and extending/contracting movement.

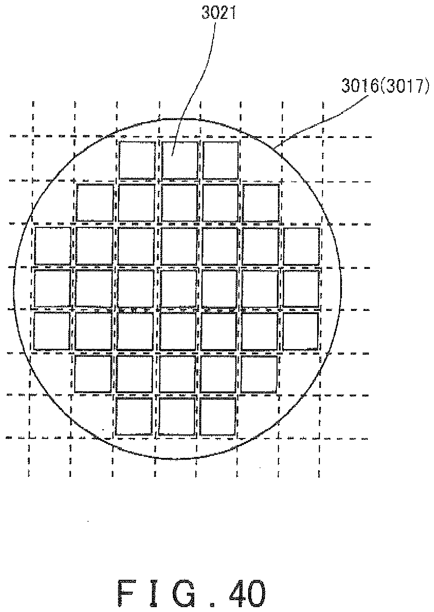

Fig. 40 is a planar view schematically showing a semiconductor wafer according to the present embodiment. The first substrate 3016 and the second substrate 3017, which are semiconductor wafers, are each formed of a circular thin board member made of single-crystal silicon, and each have one surface on which a plurality of circuit regions 3021 are formed. The circuit regions 3021 are partitioned into a matrix, and circuit elements such as transistors, resistors, and capacitors are formed therein. The circuit elements are formed using mainly lithography techniques such as thin film formation, etching, or impurity diffusion. Alignment marks are provided within each of the circuit regions 3021. The alignment marks are indicators used to align the substrates with each other. The plurality of alignment marks provided on each of the first substrate 3016 and the second substrate 3017 have their set coordinate values stored independently and managed in a memory. The semiconductor wafers to be layered may be semiconductor wafers that have already been layered with other semiconductor wafers. In this case, the previously layered circuit layers preferably undergo a thinning process to remove unnecessary thickness.

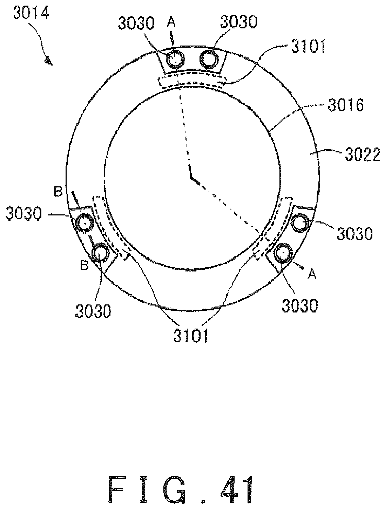

Fig. 41 is a planar view schematically showing the first substrate holder 3014 holding the first substrate 3016. The first substrate holder 3014 includes a holder body 3022 and an attraction unit 3030, which serves as an engaging section, and is shaped as a circular board with a diameter larger than that of the first substrate 3016. The holder body 3022 is formed integrally using a material with high rigidity such as ceramic or metal.

The holder body 3022 has a mounting region for holding and mounting the first substrate 3016 on the surface thereof. This mounting region is polished to be extremely flat. In Fig. 41, almost all of the region surrounded by the outer circumference of the first substrate 3016 corresponds to the mounting region. The holding of the first substrate 3016 is achieved by adhesion that uses electrostatic force. A detailed configuration is described further below. The adhesion surface of the first substrate 3016 is the surface opposite the surface on which the circuit regions 3021 are provided.

Each attraction unit 3030 includes a plurality of peripheral regions, which are arranged further outward than the first substrate 3016 mounting region of the on the surface that holds the first substrate 3016. In the example shown in the drawings, sets that each include two attraction units 3030 are arranged at intervals of 120 degrees to obtain a total of six attraction units 3030. A more detailed configuration is described further below.

The first substrate holder 3014 includes a first dust trapping region 3101, which traps dust, between the first substrate 3016 mounting region and each attraction unit 3030. In the drawings, a first dust trapping region 3101 is provided between each set of attraction units 3030 and the first substrate 3016 mounting region, but the number of first dust trapping regions 3101 may instead correspond to the number of attraction units 3030. The first dust trapping regions 3101 are regions that use electrostatic force to trap dust that is scattered from the attraction units 3030, in particular. A detailed configuration is described further below.

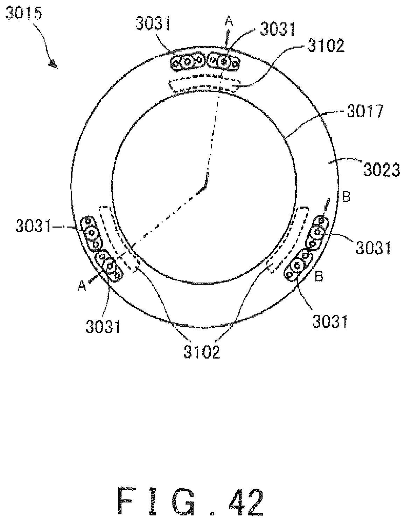

Fig. 42 is a planar view schematically showing the second substrate holder 3015 holding the second substrate 3017. The second substrate holder 3015 includes a holder body 3023 and a magnet unit 3031, which serves as an engaging section, and is shaped as a circular board with a diameter larger than that of the second substrate 3017. The holder body 3023 is formed integrally using a material with high rigidity such as ceramic or metal.

The holder body 3023 has a mounting region for holding and mounting the second substrate 3017 on the surface thereof. This mounting region is polished to be extremely flat. In Fig. 42, almost all of the region surrounded by the outer circumference of the second substrate 3017 corresponds to the mounting region. The holding of the second substrate 3017 is achieved by adhesion that uses electrostatic force. A detailed configuration is described further below. The adhesion surface of the second substrate 3017 is the surface opposite the surface on which the circuit regions 3021 are provided.

Each magnet unit 3031 includes a plurality of peripheral regions, which are arranged further outward than the second substrate 3017 mounting region on the surface that holds the second substrate 3017. In the example shown in the drawings, sets that each include two magnet units 3031 are arranged at intervals of 120 degrees to obtain a total of six magnet units 3031.

Each magnet unit 3031 is arranged to correspond to an attraction unit 3030 of the first substrate holder 3014. When the first substrate holder 3014 holding the first substrate 3016 and the second substrate holder 3015 holding the second substrate 3017 face each other and the attraction unit 3030 and magnet unit 3031 are made to operate, the first substrate 3016 and the second substrate 3017 can be sandwiched and fixed in a stacked state. This sandwiched and fixed state is the substrate holder pair 3018. Detailed descriptions of the configuration and adhesion operation are described further below.

The second substrate holder 3015 includes a second dust trapping region 3102, which traps dust, between the second substrate 3017 mounting region and each magnet unit 3031. In the drawings, a second dust trapping region 3102 is provided between each set of magnet units 3031 and the second substrate 3017 mounting region, but the number of second dust trapping regions 3102 may instead correspond to the number of magnet units 3031. The second dust trapping regions 3102 are regions that use electrostatic force to trap dust that is scattered from the magnet units 3031, in particular. A detailed configuration is described further below.

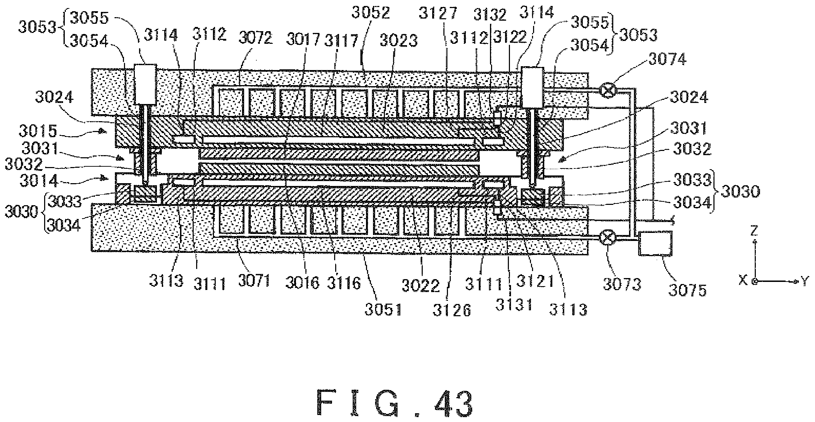

Fig. 43 is a cross-sectional view schematically showing a state immediately before the substrate holder pair 3018 is formed by the alignment apparatus 3011. Specifically, Fig. 43 is a cross-sectional view of a state in which the first substrate holder 3014 holding the first substrate 3016 is fixed to the first stage 3051 of the alignment apparatus 3011 by vacuum suction and the second substrate holder 3015 holding the second substrate 3017 is fixed to the second stage 3052 of the alignment apparatus 3011 by vacuum suction. In particular, the cross-sectional view is over the line A-A in Figs. 41 and 42.

The first substrate holder 3014 is fixed to the front surface of the first stage 3051 by a vacuum suction force exerted by a suction apparatus 3075 via a first suction piping 3071 passing through the first stage 3051 to reach the front surface thereof. The first suction piping 3071 includes a plurality of branches reaching the front surface of the first stage 3051, and exerts uniform suction over a wide region on the back surface of the first substrate holder 3014. The suction force of the suction apparatus 3075 is adjusted by a first valve 3073, in order to control attachment and detachment of the first substrate holder 3014.

Similarly, the second substrate holder 3015 is fixed to the front surface of the second stage 3052 by a vacuum suction force exerted by a suction apparatus 3075 via a second suction piping 3072 passing through the second stage 3052 to reach the front surface thereof. The second suction piping 3072 includes a plurality of branches reaching the front surface of the second stage 3052, and exerts uniform suction over a wide region on the back surface of the second substrate holder 3015. The suction force of the suction apparatus 3075 is adjusted by a second valve 3074, in order to control attachment and detachment of the second substrate holder 301 5.

The first stage 3051 can move the first substrate 3016 relative to the second substrate 3017, in a Z-axis direction that is the layering direction and X-axis and Y-axis directions that are each orthogonal to the Z-axis. The alignment apparatus 3011 aligns the first substrate 3016 and the second substrate 3017, by using a first microscope arranged on the alignment apparatus 3011 in a manner to be able to observe the first substrate 3016 and a second microscope arranged on the alignment apparatus 3011 in a manner to be able to observe the second substrate 3017.

More specifically, each microscope is used to capture images of the alignment marks on each substrate serving as an observation target, and precise positions of the alignment marks are detected by performing image processing on the captured image data. The positional skew amount between corresponding alignment marks is then calculated and the first stage 3051 is moved according to this positional skew amount, thereby aligning the first substrate 3016 and the second substrate 3017. In this way, each circuit region 3021 of the first substrate 3016 faces a corresponding circuit region 3021 of the second substrate 3017. The positional skew amount calculation may be performed using a global alignment technique, for example, in which the positional skew amount is statistically determined to have a minimum value when the plurality of alignment marks of the first substrate 3016 overlap the plurality of alignment marks of the second substrate 3017.

When aligning the first substrate 3016 with the second substrate 3017, i.e. when moving the first stage 3051 in the XY-plane, a small gap is maintained between the first substrate 3016 and the second substrate 3017 such that the substrates do not contact each other. The second stage 3052 includes a plurality of engagement control units 3053, such that the attraction units 3030 do not engage with the magnet units 3031 when in this state.

Each engagement control unit 3053 is mainly formed from a push pin 3054, which is a member shaped as a pillar, and a cylinder portion 3055 that drives the push pin 3054. When at an extended position, the push pin 3054 passes through a holder insertion hole 3024 that is provided in the second substrate holder 3015 and a magnet insertion hole 3032 provided in the magnet unit 3031 arranged to be aligned with the holder insertion hole 3024, such that the tip of the push pin 3054 protrudes beyond the magnet insertion hole 3032. When at a storage position, a portion of the push pin 3054 is stored within the cylinder portion 3055, and is withdrawn from the insertion holes. In other words, the push pin 3054 moves back and forth in the Z-axis direction within the insertion holes, according to the drive of the cylinder portion 3055.

When the first substrate 3016 and the second substrate 3017 are to be moved relative to each other in the XY-plane, such as shown in Fig. 43, the push pins 3054 are held at the extended position in contact with the top surfaces of the attraction units 3030, thereby preventing the attraction units 3030 from engaging with the magnet units 3031. In other words, the attraction units 3030 are formed by attracting elements 3033 and flat springs 3034 fixed to the attracting elements 3033, but the push pins 3054 press on the attracting elements 3033 from above to restrict the elastic deformation of the flat springs 3034, such that the attracting elements 3033 do not engage with the magnet units 3031 as a result of the elastic deformation of the flat springs 3034.

The alignment of the first substrate 3016 and the second substrate 3017 by the alignment apparatus 3011 is performed at a final fine adjustment stage in which the movement amount is such that the tips of the push pins 3054 slide along the top surfaces of the attraction units 3030. At other stages, such as an observation stage in which the alignment marks are observed by the microscopes, the first substrate 3016 and the second substrate 3017 are separated from each other by a large amount in the X-, Y-, and Z-axis directions, and therefore the attraction units 3030 do not unexpectedly engage with the magnet units 3031. Accordingly, the push pins 3054 are held at the extended position when the magnetic force of the magnet units 3031 is exerted on the attraction units 3030 and engaging therebetween is to be prevented, and are held at the stored position at all other times.

A first substrate electrode 3116 is embedded in the holder body 3022 of the first substrate holder 3014, to correspond to the first substrate 3016 mounting region. The first substrate electrode 3116 is connected to a first voltage application terminal 3121 by a first substrate wiring 3126. The first voltage supply terminal 3131 is embedded in the first stage 3051 at a position corresponding to the first voltage application terminal 3121, and when the first substrate holder 3014 is fixed to the first stage 3051, the first voltage application terminal 3121 is connected to the first voltage supply terminal 3131. The first voltage supply terminal 3131 is supplied with voltage from an external power supply, via a conductive line embedded through the first stage 3051. The voltage supply from the external power supply to the first voltage supply terminal 3131 is controlled by a control section of the alignment apparatus 3011. With this configuration, a potential difference is generated between the first substrate 3016 and the first substrate holder 3014, and therefore the first substrate 3016 is adhered to the mounting region of the first substrate holder 3014 by electrostatic force, and the bias toward the first substrate holder 3014 is maintained.

A second substrate electrode 3117 is embedded in the holder body 3023 of the second substrate holder 3015, to correspond to the second substrate 3017 mounting region. The second substrate electrode 3117 is connected to a second voltage application terminal 3122 by a second substrate wiring 3127. The second voltage supply terminal 3132 is embedded in the second stage 3052 at a position corresponding to the second voltage application terminal 3122, and when the second substrate holder 3015 is fixed to the second stage 3052, the second voltage application terminal 3122 is connected to the second voltage supply terminal 3132. The second voltage supply terminal 3132 is supplied with voltage from an external power supply, via a conductive line embedded through the second stage 3052. The voltage supply from the external power supply to the second voltage supply terminal 3132 is controlled by a control section of the alignment apparatus 3011. With this configuration, a potential difference is generated between the second substrate 3017 and the second substrate holder 3015, and therefore the second substrate 3017 is adhered to the mounting region of the second substrate holder 3015 by electrostatic force, and the bias toward the second substrate holder 3015 is maintained.

A first dust trapping electrode 3111 is also embedded in the holder body 3022 of the first substrate holder 3014, corresponding to the first dust trapping region 3101. The first dust trapping electrode 3111 is connected to the first voltage application terminal 3121 by a first dust wiring 3113. Accordingly, when the first substrate holder 3014 is fixed to the first stage 3051, the first dust trapping electrode 3111 is also supplied with voltage. With this configuration, when voltage is supplied to the first dust trapping electrode 3111, the first dust trapping region 3101 becomes charged. The floating dust often has a negative charge, and therefore when the first dust trapping region 3101 is supplied with voltage from the first dust trapping electrode 3111 to have a positive charge, this dust is drawn in and adhered to the first dust trapping region 3101.

In the manner described above, the voltage supply to the first substrate electrode 3116 and the voltage supply to the first dust trapping electrode 3111 are supplied via a common first voltage application terminal 3121. However, the line resistances of the first substrate wiring 3126 and the first dust wiring 3113 may be set to be different from each other, in order to create a difference between the electrostatic attractive force per unit area in the first substrate 3016 mounting region and the electrostatic attractive force per unit area in the first dust trapping region 3101. Specifically, in order to exert a stronger attractive force on the floating dust, the electrostatic attractive force per unit area in the first dust trapping region 3101 may be set to be greater than the electrostatic attractive force per unit area in the first substrate 3016 mounting region.

The external contours of the first dust trapping electrode 3111 and the first substrate electrode 3116 and the position of the embedding in the holder body 3022 are determined such that the forms of the first dust trapping electrode 3111 and the first substrate electrode 3116, as projected in a direction in which the first substrate 3016 is mounted, do not overlap each other. As a result, the first substrate 3016 mounting region and the first dust trapping region 3101 can be distanced from each other, thereby avoiding movement of the trapped dust toward the first substrate 3016.

A second dust trapping electrode 3112 is also embedded in the holder body 3023 of the second substrate holder 3015, corresponding to the second dust trapping region 3102. The second dust trapping electrode 3112 is connected to the second voltage application terminal 3122 by a second dust wiring 3114. Accordingly, when the second substrate holder 3015 is fixed to the second stage 3052, the second dust trapping electrode 3112 is also supplied with voltage. With this configuration, when voltage is supplied to the second dust trapping electrode 3112, the second dust trapping region 3102 becomes charged. In the same manner as the first dust trapping region 3101, if the second dust trapping region 3102 is supplied with voltage from the second dust trapping electrode 3112 to have a positive charge, dust can be drawn in and adhered to the second dust trapping region 3102.

In the same manner as the first substrate holder 3014, the electrostatic attractive force per unit area in the second dust trapping region 3102 is preferably set to be greater than the electrostatic attractive force per unit area in the second substrate 3017 mounting region. Furthermore, the external contours of the second dust trapping electrode 3112 and the second substrate electrode 3117 and the position of the embedding in the holder body 3023 are determined such that the forms of the second dust trapping electrode 3112 and the second substrate electrode 3117, as projected in a direction in which the second substrate 3017 is mounted, do not overlap each other.

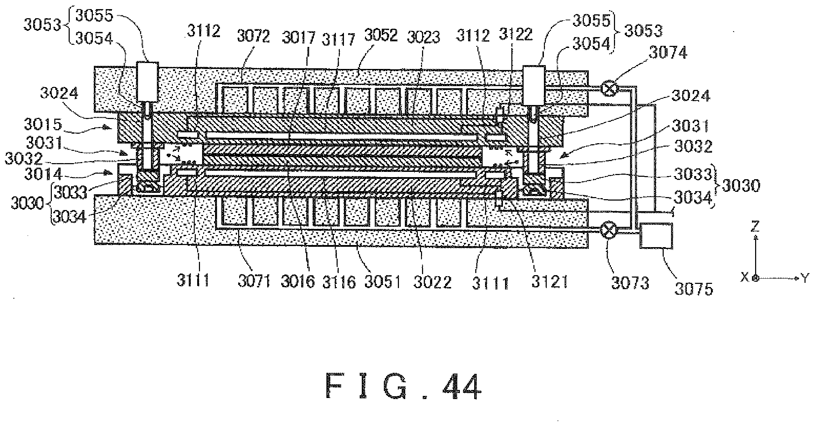

Fig. 44 is a cross-sectional view schematically showing a state immediately after formation of the substrate holder pair 3018 by the alignment apparatus 3011. Specifically, Fig. 44 shows a state in which the first stage 305 1 has been driven in the Z-axis direction from the state shown in Fig. 43, such that the surface of the first substrate 3016 contacts the surface of the second substrate 3017, the push pins 3054 are held at the storage position, and the attraction units 3030 and magnet units 3031 are engaged.

During the process of transitioning from the state of Fig. 43 to the state of Fig. 44, the first substrate 3016 and the second substrate 3017 are aligned, and the magnet units 3031, which are engaging members, are engaged with the attraction units 3030, which are engagement receiving members. The first substrate holder 3014 and the second substrate holder 3015 are then formed integrally, thereby forming the substrate holder pair 3018 as the substrate holder system.

When the flat springs 3034 deform and the attraction units 3030 engage with the magnet units 3031, the engagement of the attracting elements 3033 of the attraction units 3030 with the magnet units 3031 is accompanied by a small impact. At this time, dust can be generated and scattered by the impact of the engagement of the attraction units 3030 and the magnet units 3031. When this dust becomes stuck between the first substrate 3016 and the second substrate 3017 and in nearby regions, the non-uniform heating and pressurization and a decrease in bonding strength can occur in the bonding process performed later by the bonding apparatus 3012. Furthermore, the completed semiconductor device can experience defects in circuit operation due to the dust therein.

In order to solve such problems, in the present embodiment, for at least some time from when the attraction units 3030 contact the magnet units 3031, the control section supplies voltage to the first dust trapping electrode 3111 and the second dust trapping electrode 3112 to trap scattered dust in the first dust trapping region 3101 and the second dust trapping region 3102. By adopting this configuration, the generated dust is expected to be withdrawn prior to entering between the first substrate 3016 and the second substrate 3017.

After the substrate holder pair 3018 is formed, the substrate holder pair 3018 is released from the vacuum suction of the second stage 3052, lifted up by the first stage 3051, and transported to the bonding apparatus 3012 by the transport apparatus 3013. The transportation mechanism of the transport apparatus 3013 and the bonding process of the bonding apparatus 3012 are described further below.

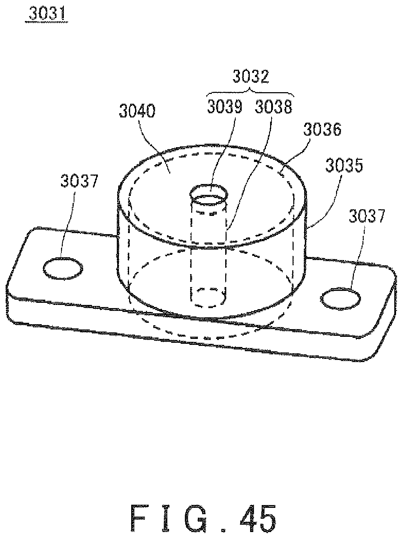

The following describes a configuration of the magnet unit 3031. Fig. 45 is a perspective view schematically showing the magnet unit 3031. The magnet unit 3031 includes a magnet 3036 and a support section 3035 housing the magnet 3036.

The support section 3035 includes a housing portion shaped as a circular cylinder that houses the magnet 3036, and a threaded hole 3037 through which passes a screw for fixing the support section 3035 to the second substrate holder 3015. The support section 3035 is formed by carbon steel S25C, for example. The support section 3035 has a counterface surface 3040 that faces the attracting element 3033. The magnet 3036 is a permanent magnet shaped as a circular pillar that can be inserted into the housing portion of the support section 3035, and may have a magnetic force of approximately 8 N, for example. The central axis of the magnet 3036 is provided with an insertion hole 3038 into which is inserted a push pin 3054, and an insertion hole 3039 in series with the insertion hole 3038 and into which the support section 3035 is inserted. The magnet insertion hole 3032 is formed by these two insertion holes.

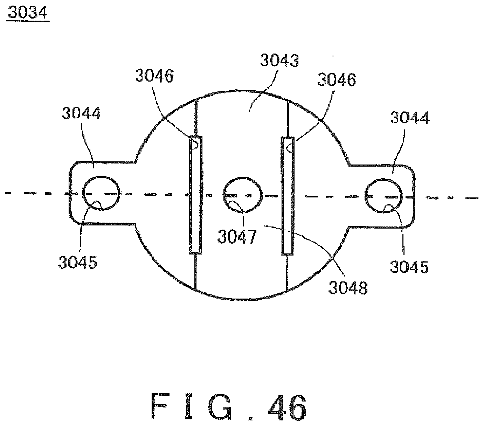

The following describes a configuration of an attraction unit 3030. Fig. 46 is a planar view schematically showing a flat spring 3034 of the attraction unit 3030. The flat spring 3034 is an elastic member having elasticity in a direction orthogonal to the holding surface of the second substrate holder 3015 that holds the second substrate 3017, and may be formed of a high-strength precipitation-hardening stainless steel, such as SUS 631. The flat spring 3034 is formed by a central circular portion 3043 and attaching sections 3044 protruding therefrom as ears. The circular portion 3043 has a diameter of 22 mm and a thickness of 0.1 mm.

A pair of slits 3046 that extend in the same direction as each other are arranged in the circular portion 3043 with an interval therebetween in a direction orthogonal to the extension direction. Each slit 3046 is the same distance from the center of the circular portion 3043. The two slits 3046 form a band-shaped portion 3048 in the central region of the circular portion 3043. A through-hole 3047 that fixes the attracting element 3033 is formed in the band-shaped portion 3048 at the center of the circular portion 3043. Similarly, each attaching section 3044 includes a threaded hole 3045 through which passes a screw for fixing the flat spring 3034 to the second substrate holder 3015. The flat spring 3034 is arranged in a peripheral region of the holder body 3023, such that the two threaded holes 3045 are oriented along a circumferential direction of the second substrate holder 3015 and the extension direction of each slit 3046 is oriented along the radial direction of the second substrate holder 3015.

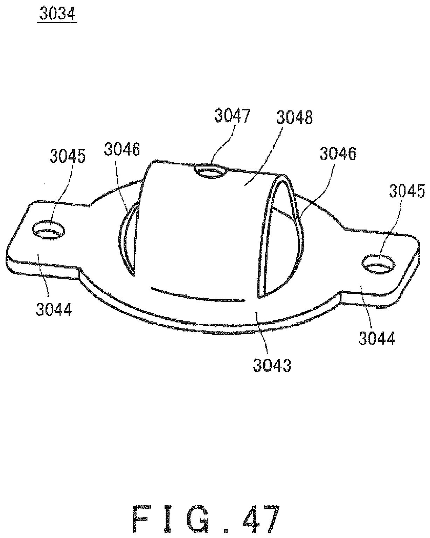

Fig. 47 is a perspective view schematically showing a state in which the flat spring 3034 is elastically deformed. Specifically, Fig. 47 shows a state in which the attracting element 3033 fixed to the flat spring 3034 is engaged with the magnet unit 3031 via attraction. It should be noted that the attracting element 3033 is not shown in Fig. 47.

In the flat spring 3034, as a result of the attracting element 3033 being attracted to the magnet unit 3031, the band-shaped portion 3048 rises upward such that that the through-hole 3047 becomes a peak, and the therefore two portions of the periphery of the circular portion 3043 connected to the band-shaped portion 3048 are deformed to draw closer to each other. At this time, the shapes of the openings in the slits 3046 are deformed to allow for the above deformation.

Fig, 48 is a perspective view including the attracting element 3033 when the flat spring 3034 of Fig. 47 is in the deformed state. The attracting element 3033 is fixed to the flat spring 3034 via the through-hoie 3047, by a fastening member such as a screw. The attracting element 3033 is formed by a ferromagnetic body. For example, the attracting element 3033 may be formed of carbon steel S25C.

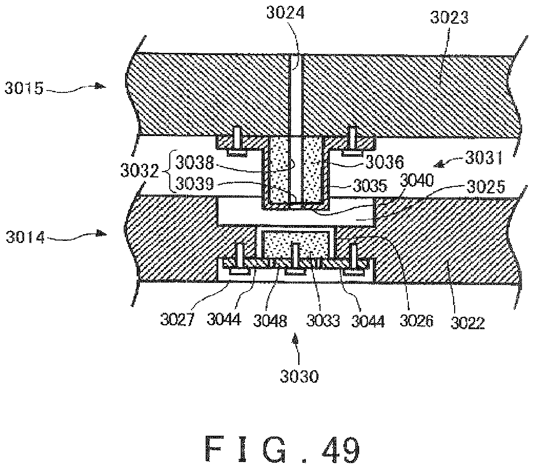

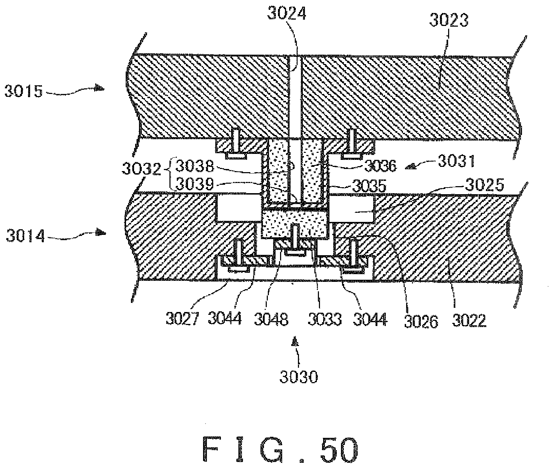

Fig. 49 is a cross-sectional view showing the coupling operation between the magnet unit 3031 and the attraction unit 3030. In particular, Fig. 49 shows a cross section over the line B-B in Figs. 41 and 42. The first substrate 301 6, the second substrate 3017, the push pin 3054, etc. are omitted from the drawing. Fig. 49 shows a state before the attracting element 3033 engages with the magnet unit 3031. Fig. 50 shows a state after the attracting element 3033 has engaged with the magnet unit 3031, using the same cross-sectional view as Fig. 49.

As shown in the drawings, the magnet unit 3031 is fixed to the surface of the second substrate holder 3015 by a screw. The counterface surface 3040 facing the attracting element 3033 is positioned below the first substrate 3016 holding surface of the first substrate holder 3014. In other words, the first substrate holder 3014 includes a recessed portion 3025 having a surface that is lower than the first substrate 3016 holding surface and corresponding to the region in which the attraction unit 3030 is provided. Specifically, the counterface surface 3040, which is the expected contact surface of the magnet unit 3031 expected to contact the attracting element 3033, is positioned within the recessed portion 3025 when the front surface of the first substrate 3016 and the front surface of the second substrate 3017 are in contact.

The recessed portion 3025 includes a through-hole 3026 that allows the attracting element 3033 to move up and down. The back surface of the first substrate holder 3014, which is the side opposite the surface holding the first substrate 3016, includes a recessed portion 3027 around the through-hole 3026, and the flat spring 3034 and a screw fixing the flat spring 3034 to the first substrate holder 3014 are arranged to be housed within the recessed portion.

As shown by the change from the state of Fig. 49 to the state of Fig. 50, the band-shaped portion 3048 to which the attracting element 3033 is affixed elastically deforms as a result of the attracting element 3033 being attracted by the magnet 3036. At this time, the attaching sections 3044 are fixed to the first substrate holder 3014, and therefore the flat spring 3034 biases the first substrate holder 3014 and the second substrate holder 3015 to draw closer to each other, by sandwiching the second substrate 3017 with the first substrate 3016.

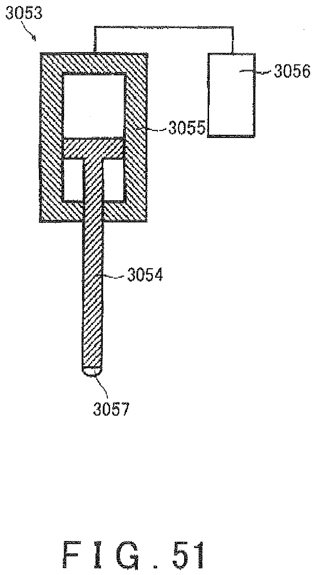

Fig. 51 is a cross-sectional view schematically showing the engagement control unit 3053. A plurality of engagement control units 3053 are arranged on the second substrate holder 3015, corresponding to the magnet units 3031. The cylinder portion 3055 is connected to an air pump 3056 that adjusts the atmospheric pressure within the cylinder portion 3055. The control section causes the push pin 3054 to extend and retract by controlling the air pump 3056. More specifically, the control section causes the push pin 3054 to be at the stored position in which at least a portion of the push pin 3054 is within the cylinder portion 3055 or at the extended position in which the tip 3057 of the push pin 3054 presses the attracting element 3033. Accordingly, the pressing force exerted by the push pin 3054 on the attracting element 3033 is large enough to resist the elastic force of the flat spring 3034. The tip 3057 of the push pin 3054 is machined to have a spherical shape, in order to achieve point contact with the attracting element 3033.

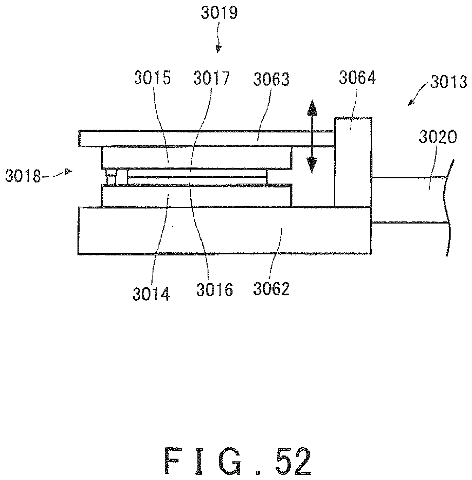

Fig. 52 is a side view schematically showing a state in which the transport apparatus 3013 grips the substrate holder pair 3018. The transport apparatus 3013 includes an arm portion 3020 and a gripping section 3019 that is connected to the arm portion 3020. The gripping section 3019 includes a support board 3062 that supports the substrate holder pair 3018 from below and a presser plate 3063 that presses the substrate holder pair 3018 from above. The support board 3062 includes a suction hole that fixes the substrate holder pair 3018 thereto using vacuum suction, and the substrate holder pair 3018 is fixed to the support board 3062 as a result of this suction.

The presser plate 3063 is provided on a support column 3064 formed on one end of the support board 3062, and can move back and forth in a direction to sandwich the substrate holder pair 3018. The presser plate 3063 exerts a pressing force on the substrate holder pair 3018 fixed to the support board 3062, such that the substrate holder pair 3018 can be sandwiched by the presser plate 3063 and the support board 3062. As a result of the arm portion 3020 moving while in this state, the transport apparatus 3013 transports the substrate holder pair 3018 from the alignment apparatus 3011 to the bonding apparatus 3012, The transport apparatus 3013 can supply voltage to the first voltage application terminal 3121 and the second voltage application terminal 3122 during transport as well. In this way, the first substrate 3016 and the second substrate 3017 can be adhered the substrate holders using electrostatic force, and there is no worry that the substrates and substrate holders will shift relative to each other during transport.

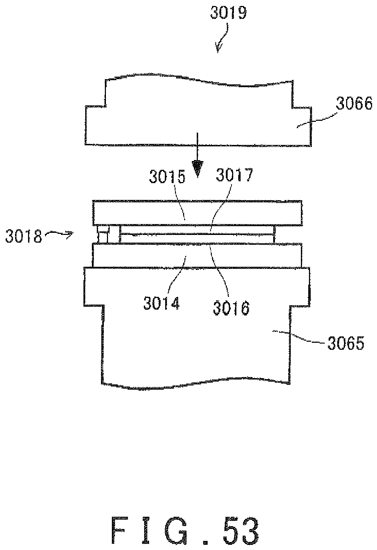

Fig. 53 is a side view schematically showing essential portions of the bonding apparatus 3012. The bonding apparatus 3012 includes a lower pressuring stage 3065 arranged below the first substrate holder 3014 and an upper pressuring stage 3066 arranged above the second substrate holder 3015. The upper pressuring stage 3066 can move toward the lower pressuring stage 3065, in order to apply pressure to the substrate holder pair 3018 together with the lower pressuring stage 3065. The lower pressuring stage 3065 and the upper pressuring stage 3066 each house a heater therein, and can therefore also apply heat to the substrate holder pair 3018 mounted thereon in addition to applying pressure. As a result of the pressure and heat being applied to the substrate holder pair 3018, the electrodes of the first substrate 3016 and the second substrate 3017 in contact with each other are fused together. As a result, the corresponding circuit regions 3021 of the first substrate 3016 and the second substrate 3017 are bonded together.

### (First Modification of Third Embodiment)

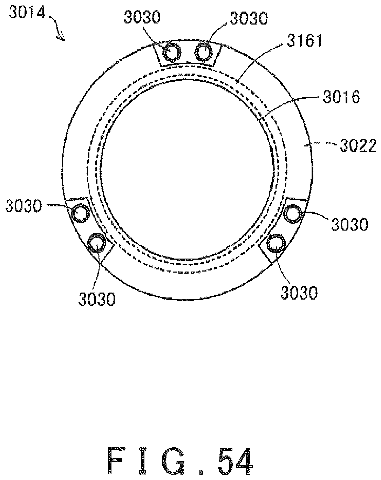

Fig. 54 is a planar view schematically showing a first substrate holder 3014 including a dust trapping region, as a first modification of the third embodiment. The first substrate holder 3014 described using Fig. 41 includes a first dust trapping region 3101 that traps dust between the first substrate 3016 mounting region and each attraction unit 3030. In contrast to this, the present modification includes a dust trapping region 3161 formed as a ring that surrounds the first substrate 3016 mounting region and formed by connecting the first dust trapping regions 3101. A dust trapping electrode is also formed as a ring and embedded in the holder body 3022 to correspond to the dust trapping region 3161.

A ring-shaped dust trapping region is also formed in the second substrate holder 3015, corresponding to the dust trapping region 3161 of the first substrate holder 3014. The substrate holder pair 3018 with this configuration can be expected to withdraw not only the dust generated by the bonding impact between the attraction unit 3030 and the magnet unit 3031, but also the dust that is scattered in the surrounding atmosphere, thereby preventing dust from entering between the first substrate 3016 and the second substrate 3017.

### (Second Modification of Third Embodiment)

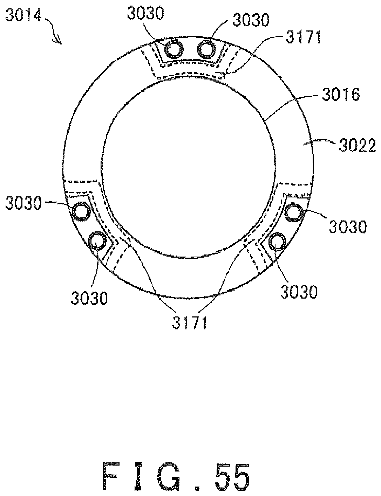

Fig. 55 is a planar view schematically showing a first substrate holder 3014 including a dust trapping region, as a second modification of the third embodiment. The first substrate holder 3014 described using Fig. 41 includes an arc-shaped first dust trapping region 3101 that traps dust between the first substrate 3016 mounting region and each attraction unit 3030. In contrast to this, the present modification includes, in addition to these arc-shaped regions, a dust trapping region 3171 formed as a ring that surrounds the attraction units 3030. A dust trapping electrode is also formed and embedded in the holder body 3022 to surround the attraction units 3030, and corresponds to the dust trapping region 3171.

A ring-shaped dust trapping region surrounding the magnet units 3031 is also formed in the second substrate holder 3015, corresponding to the dust trapping region 3161 of the first substrate holder 3014. The substrate holder pair 3018 with this configuration can more reliably trap the dust generated by the bonding impact between the attraction units 3030 and the magnet units 3031.

### (Third Modification of Third Embodiment)

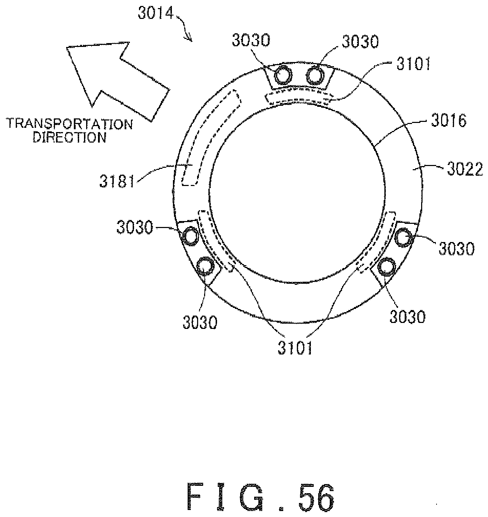

Fig. 56 is a planar view schematically showing a first substrate holder 3014 including a dust trapping region, as a third modification of the third embodiment. The first substrate holder 3014 described using Fig. 41 includes a first dust trapping region 3101 that traps dust between the first substrate 3016 mounting region and each attraction unit 3030. In contrast to this, the present modification includes a mid-transportation dust trapping region 3181 in addition to the first dust trapping regions 3101. A mid-transport dust trapping electrode is embedded in the holder body 3022 to correspond to the mid-transportation dust trapping region 3181.

When the first substrate holder 3014 is transported by the transport apparatus 3013 or other apparatuses such as a slider mechanism, the bias of the first substrate holder 3014 in the transportation direction is often determined in advance. Therefore, the mid-transportation dust trapping region 3181 is provided in a region on the transportation direction side of the first substrate holder 3014 to prevent dust from sticking to the first substrate 3016, by trapping dust that flies in from the transportation direction. When the first substrate holder 3014 is transported by the transport apparatus 3013 or another apparatus such as a slider mechanism, the bias of the first substrate holder 3014 on the transport apparatus 3013 may be controlled such that the mid-transportation dust trapping region 3181 is on the transportation direction side.

A mid-transportation dust trapping region 3181 is also provided on the second substrate holder 3015 to correspond to the mid-transportation dust trapping region 3181 of the first substrate holder 3014. The substrate holder pair 3018 with this configuration can be expected to withdraw not only the dust generated by the bonding impact between the attraction unit 3030 and the magnet unit 3031, but also the dust that is scattered in the surrounding atmosphere, thereby preventing dust from entering between the first substrate 3016 and the second substrate 3017.

The objective of the first dust trapping region 3101 and the second dust trapping region 3102 is to trap the dust generated by the bonding impact between the attraction, units 3030 and the magnet units 3031, and the objective of the mid-transportation dust trapping region 3181 is to trap dust that flies in during transport. Accordingly, the periods during which these regions operate are different from each other. Specifically, the period during which the first dust trapping region 3101 and the second dust trapping region 3102 operate is a period spanning a certain time from when the attraction units 3030 contact the magnet units 3031, and the period during which the mid-transportation dust trapping regions 3181 operate is a period during which the first substrate holder 3014 and the second substrate holder 3015 are transported individually or a period during which the first substrate holder 3014 and the second substrate holder 3015 are transported as the substrate holder pair 3018. The mid-transport dust trapping electrodes are wired such that voltage can be applied independently to the first dust trapping electrode 3111 and the second dust trapping electrode 3112, and the control section can operate the dust trapping regions selectively according to the circumstances.

If there is no dust generated by the bonding impact between the attraction units 3030 and the magnet units 3031 or if the amount of dust is small enough to ignore, the first dust trapping region 3101 and the second dust trapping region 3102 can be omitted. In this case, only the mid-transportation dust trapping region 3181 is provided, in order to trap the dust that flies in during transport.

In the embodiments and modifications described above, the first substrate 3016 and the second substrate 3017 are fixed respectively to the first substrate electrode 3116 and the second substrate electrode 3117 by electrostatic adhesion. However, the adhesion of the substrates is not limited to electrostatic adhesion. Suction holes may be formed in each holder to exert a suction force, thereby fixing the substrates thereto via suction adhesion. In this case as well, the dust floating in the dust trapping regions can be attracted by electrostatic force.

When the first substrate holder 3014 and the second substrate holder 3015 are used to manufacture a device via a substrate bonding apparatus 3010, the process for stacking the first substrate 3016 and the second substrate is as described below. This process includes mounting the first substrate 3016 on the first substrate holder 3014, mounting the second substrate 3017 on the second substrate holder 3015, and forming the first substrate holder 3014 and the second substrate holder 3015 integrally by engaging the attraction units 3030 with the magnet units 3031, while generating an electrostatic force via conduction through at least one of the first dust trapping electrode 3111 and the second dust trapping electrode 3112.

The process for transporting the first substrate 3016 as a substrate before being formed as a chip is as described below. This process includes mounting the first substrate 3016 on the first substrate holder 3014 and transporting the first substrate 3016 together with the first substrate holder 3014, while generating an electrostatic force via conduction through the mid-transport dust trapping electrode.

By including the dust How inhibiting section described in each of the above embodiments, the occurrence of dust that can be generated by each process in the substrate bonding apparatus and the dust generated from the substrate holders themselves can be restricted, or can be prevented from flowing and sticking to the regions sandwiching the substrates.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention, which is defined by the appended claims.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims. embodiments, or diagrams, it does not necessarily mean that the process must be performed in this order.

### [List of Reference Numerals]

1010 substrate bonding apparatus, 1011 alignment apparatus, 1012 bonding apparatus, 1013 transport apparatus, 1014 first substrate holder, 1015 second substrate holder, 1016 first substrate, 1017 second substrate, 1018 substrate holder pair, 1019 gripping section, 1020 aim portion, 1021 circuit region, 1022 1023 holder body, 1024 holder insertion hole, 1025 recessed portion, 1026, through-hole, 1027 recessed portion, 1030 attraction unit, 1031 magnet unit, 1032 magnet insertion hole, 1033 attracting element, 1034 flat spring, 1035 support section, 1036 magnet, 1037 threaded hole, 1038 1039 insertion hole, 1040 counterface surface, 1041 spherical protrusion 1042 fixing member, 1043 circular portion, 1044 attaching section, 1045 threaded hole, 1046 slit, 1047 through-hole, 1048 band-shaped portion, 1049 buffer plate, 1050 linear protrusion, 1051 first stage, 1052 second stage, 1053 engagement control unit, 1054 push pin, 1055 cylinder portion, 1056 air pump, 1057 tip, 1062 support board, 1063 presser plate, 1064 support column, 1065 lower pressuring stage, 1066 upper pressuring stage, 2010 substrate bonding apparatus, 2011 alignment apparatus, 2012 bonding apparatus, 2013 transport apparatus, 2014 first substrate holder, 2015 second substrate holder, 2016 first substrate, 2017 second substrate, 2018 substrate holder pair, 2019 gripping section, 2020 arm portion, 2021 circuit region, 2022 2023 holder body, 2024 holder insertion hole, 2025 recessed portion, 2026 through-hole, 2027 recessed portion, 2030 attraction unit, 2931 magnet unit, 2032 magnet insertion hole, 2033 attracting element, 2034 flat spring, 2035 support section, 2036 magnet, 2037 threaded hole, 2038 2039 insertion hole, 2040 counterface surface, 2044 attaching section 2045 threaded hole, 2046 slit, 2047 through-hole, 2048 band-shaped portion, 2051 first stage, 2052 second stage, 2053 engagement control unit, 2054 push pin, 2055 cylinder portion, 2056 air pump, 2057 tip, 2062 support board, 2063 presser plate, 2064 support column, 2065 lower pressuring stage, 2066 upper pressuring stage, 2071 first suction piping, 2072 second suction piping, 2073 first valve, 2074 second valve, 2075 suction apparatus, 2101 first through-hole, 2102 second through-hole, 2111 first communicating tube, 2112 second communicating tube, 2113 third communicating tube, 2121 annular through-hole, 2131 first dust blocking wall, 2132 second dust blocking wall, 2141 shield, 3010 substrate bonding apparatus, 3011 alignment apparatus, 3012 bonding apparatus, 3013 transport apparatus, 3014 first substrate holder, 3015 second substrate holder, 3016 first substrate, 3017 second substrate, 3018 substrate holder pair, 3019 gripping section, 3020 arm portion, 3021 circuit region, 3022 3023 holder body, 3024 holder insertion hole, 3025 recessed portion, 3026 through-hole, 3027 recessed portion, 3030 attraction unit, 3031 magnet unit, 3032 magnet insertion hole, 3033 attracting element, 3034 flat spring, 3035 support section, 3036 magnet, 3037 threaded hole, 3038 3039 insertion hole, 3040 counterface surface, 3044 attaching section, 3045 threaded hole, 3046 slit, 3047 through-hole, 3048 band-shaped portion, 3051 first stage, 3052 second stage, 3053 engagement control unit, 3054 push pin, 3055 cylinder portion, 3056 air pump, 3057 tip, 3062 support board, 3063 presser plate, 3064 support column, 3065 lower pressuring stage, 3066 upper pressuring stage, 3071 first suction piping, 3072 second suction piping, 3073 first valve, 3074 second valve, 3075 suction apparatus, 3101 first dust trapping region, 3102 second dust trapping region, 3111 first dust trapping electrode, 3112 second dust trapping electrode, 3113 first dust wiring, 3114 second dust wiring, 3116 first substrate electrode, 3117 second substrate electrode, 3127 second substrate wiring, 3131 first voltage supply terminal, 3132 second voltage supply terminal, 3161 dust trapping region, 3171 dust trapping region, 3181 mid-transportation dust trapping region.

## Claims

1. A substrate holder pair comprising:
a first substrate holder (2014, 3014) that has a first holder body (2022, 3022)holding a first substrate (2016, 3016) ;
a second substrate holder (2015, 3015) that has a second holder body (2023, 3023) holding a second substrate (2017, 3017);
wherein the first substrate holder (2014, 3014) and the second substrate holder (2015, 3015) are configured to sandwich the first substrate (2016, 3016) and the second substrate (2017, 3017);
the substrate holder pair further comprising a dust flow inhibiting mechanism configured to inhibit dust from entering between the first substrate (2016, 3016) and the second substrate (2017, 3017);
**characterized in that**:
the substrate holder pair comprises a suction apparatus (2075) configured to suck dust, before entering between the first substrate (2016, 3016) and the second substrate (2017, 3017), and withdraw the dust from between the first substrate holder (2014, 3014) and the second substrate holder (2015, 3015).

2. The substrate holder pair according to Claim 1, wherein
the dust flow inhibiting mechanism includes a dust trapping region configured to trap dust and provided on at least one of the first substrate holder (2014, 3014) and the second substrate holder (2015, 3015).

3. The substrate holder pair according to Claim 2, wherein
the dust trapping region includes a first through-hole (2101, 2102) connected to a suction tube and provided between an engaging member and at least one mounting region for mounting a substrate to the at least one of the first substrate holder (2014, 3014) and the second substrate holder (2015, 3015) and configured to suck in dust through the first through-hole.

4. The substrate holder pair according to Claim 3, wherein
the dust trapping region includes a third through-hole at a position that is not between the periphery of the mounting region and the engaging member, and
the third-through hole is connected to a suction tube.

5. The substrate holder pair according to any one of Claims 1 to 4, wherein
the engaging member includes a first engaging section provided outside a first mounting region of the first substrate holder (2014, 3014) for mounting the first substrate (2016, 3016) and a second engaging section provided outside a second mounting region of the second substrate holder (2015, 3015) for mounting the second substrate (2017, 3017), and
the dust flow inhibiting mechanism includes a protruding portion provided on at least one of an engaging surface of the first engaging section and an engaging surface of the second engaging section, for achieving point contact or linear contact with the engaging surface of the other of the first engaging section and the second engaging section.

6. The substrate holder pair according to any one of Claims 1 to 5, wherein
the engaging member includes a first engaging section provided outside a mounting region of the first substrate holder (2014, 3014) for mounting the first substrate (2016, 3016) and a second engaging section provided outside a mounting region of the second substrate holder (2015, 3015) for mounting the second substrate (2017, 3017), and
the dust flow inhibiting mechanism is configured to inhibit dust generated by the engaging of the first engaging section and the second engaging section from entering between the mounting region of the first substrate holder (2014, 3014) and the mounting region of the second substrate holder (2015, 3015).

7. The substrate holder pair according to Claim 6, wherein
one of the first engaging section and the second engaging section includes a magnet and a support section that has a bonding surface and supports the magnet.

8. The substrate holder pair according to Claim 7, wherein
the other of the first engaging section and the second engaging section is a ferroelectric body.

9. The substrate holder pair according to Claim 1, wherein
a second holding portion of the second substrate holder (2015, 3015) contacts the second substrate (2017, 3017) that is stacked on and bonded with the first substrate (2016, 3016), and the second substrate holder (2015, 3015), together with the first substrate holder (2014, 3014), sandwiches the first substrate (2016, 3016) and the second substrate (2017, 3017);
the engaging member includes a first engaging section provided on the first substrate holder (2014, 3014); and a second engaging section that engages with the first engaging section and is provided on the second substrate holder (2015, 3015); and
a contact surface between the first engaging section and the second engaging section is positioned below a bonding surface between the first substrate and the second substrate in a direction of gravity.

10. The substrate holder pair according to Claim 9, wherein
the contact surface between the first engaging section and the second engaging section is positioned below whichever of the first holding portion and the second holding portion is positioned lower, in the direction of gravity.

11. The substrate holder pair according to any one of the previous claims, further comprising:
an engagement receiving member provided on the first substrate holder (2014, 3014); and
an engaging member provided on the second substrate holder (2015, 3015) and facing the engagement receiving member.

12. A substrate bonding apparatus comprising:
the substrate holder pair according to any one of Claims 1 to 11.

13. The substrate bonding apparatus according to claim 12,
further comprising a bonding section that bonds the first substrate held by the first substrate holder and the second substrate held by the second substrate holder to each other.

14. A device manufacturing method comprising manufacturing a device by stacking two substrates, the method comprising:
mounting a first substrate (2016, 3016) on a first mounting region of a first substrate holder (2014, 3014);
stacking a second substrate (2017, 3017) and the first substrate (2016, 3016) held by the first substrate holder (2014, 3014); and
fixing the two substrates in a stacked state, wherein
during the fixing, using a dust flow inhibiting mechanism to inhibit dust generated by the fixing of the fixing member from entering between the first substrate (2016, 3016) and the second substrate (2017, 3017),
**characterized in that** the method comprises:
sucking and withdrawing dust, before entering between the first substrate (2016, 3016) and the second substrate (2017, 3017), using a suction apparatus (2075).

15. The device manufacturing method according to Claim 14 wherein the first substrate holder (2014, 3014) includes a first holding portion that contacts the first substrate (2016, 3016) and a first engaging section provided outside the first holding portion;
wherein the mounting includes mounting a second substrate (2017, 3017) on a second substrate holder (2015, 3015) including a second holding portion that contacts the second substrate (2017, 3017) and a second engaging section provided outside the second holding portion;
the stacking includes stacking the first and second substrates (2016, 3016; 2017, 3017) and sandwiching the first and second substrates (2016, 3016; 2017, 3017) with the first substrate holder (2014, 3014) and the second substrate holder (2015, 3015); and
the fixing includes engaging the first engaging section and the second engaging section with each other, wherein
during the engaging, a dust flow inhibiting mechanism is used to inhibit dust generated by the engaging of the first engaging section and the second engaging section from entering between the first holding portion and the second holding portion.

## Patentansprüche

1. Substrathalterpaar, aufweisend:
einen ersten Substrathalter (2014, 3014), der einen ersten Halterkörper (2022, 3022) aufweist, der ein erstes Substrat (2016, 3016) hält;
einen zweiten Substrathalter (2015, 3015), der einen zweiten Halterkörper (2023, 3023) aufweist, der ein zweites Substrat (2017, 3017) hält;
wobei der erste Substrathalter (2014, 3014) und der zweite Substrathalter (2015, 3015) dazu ausgebildet sind, das erste Substrat (2016, 3016) und das zweite Substrat (2017, 3017) einzuklemmen;
wobei das Substrathalterpaar ferner einen Staubflusshemmmechanismus aufweist, der dazu ausgebildet ist, das Eindringen von Staub zwischen dem ersten Substrat (2016, 3016) und dem zweiten Substrat (2017, 3017) zu verhindern;
**dadurch gekennzeichnet, dass**:
das Substrathalterpaar eine Saugvorrichtung (2075) aufweist, die dazu ausgebildet ist, Staub anzusaugen, bevor er zwischen dem ersten Substrat (2016, 3016) und dem zweiten Substrat (2017, 3017) eintritt, und den Staub zwischen dem ersten Substrathalter (2014, 3014) und dem zweiten Substrathalter (2015, 3015) wegzunehmen.

2. Substrathalterpaar nach Anspruch 1, bei dem
der Staubflusshemmmechanismus einen Staubfangbereich aufweist, der dazu ausgebildet ist, Staub zu fangen, und der auf mindestens einem des ersten Substrathalters (2014, 3014) und des zweiten Substrathalters (2015, 3015) angeordnet ist.

3. Substrathalterpaar nach Anspruch 2, bei dem
der Staubfangbereich ein erstes Durchgangsloch (2101, 2102) aufweist, das mit einem Saugrohr verbunden ist und zwischen einem Eingriffselement und mindestens einem Befestigungsbereich zur Befestigung eines Substrats an dem mindestens einen des ersten Substrathalters (2014, 3014) und des zweiten Substrathalter (2015, 3015) vorgesehen ist, und dazu ausgebildet ist, Staub durch das erste Durchgangsloch anzusaugen.

4. Substrathalterpaar nach Anspruch 3, bei dem
der Staubfangbereich ein drittes Durchgangsloch an einer Stelle aufweist, die nicht zwischen dem Umfeld des Befestigungsbereichs und dem Eingriffselement liegt, und
das dritte Durchgangsloch mit einem Saugrohr verbunden ist.

5. Substrathalterpaar nach einem der Ansprüche 1 bis 4, bei dem
das Eingriffselement einen ersten Eingriffsabschnitt aufweist, der außerhalb eines ersten Befestigungsbereichs des ersten Substrathalters (2014, 3014) zum Befestigen des ersten Substrats (2016, 3016) vorgesehen ist, und einen zweiten Eingriffsabschnitt, der außerhalb eines zweiten Befestigungsbereichs des zweiten Substrathalters (2015, 3015) zum Befestigen des zweiten Substrats (2017, 3017) vorgesehen ist, und
der Staubflusshemmmechanismus einen vorstehenden Abschnitt aufweist, der auf mindestens einer der Eingriffsfläche des ersten Eingriffsabschnitts und der Eingriffsfläche des zweiten Eingriffsabschnitts vorgesehen ist, um einen Punktkontakt oder Linienkontakt mit der Eingriffsfläche des anderen des ersten Eingriffsabschnitts und des zweiten Eingriffsabschnitts zu erreichen.

6. Substrathalterpaar nach einem der Ansprüche 1 bis 5, bei dem
das Eingriffselement einen ersten Eingriffsabschnitt aufweist, der außerhalb eines Befestigungsbereichs des ersten Substrathalters (2014, 3014) zur Befestigung des ersten Substrats (2016, 3016) vorgesehen ist, und einen zweiten Eingriffsabschnitt, der außerhalb eines Befestigungsbereichs des zweiten Substrathalters (2015, 3015) zur Befestigung des zweiten Substrats (2017, 3017) vorgesehen ist, und
der Staubflusshemmmechanismus dazu ausgebildet ist, zu verhindern, dass Staub, der durch das Eingreifen des ersten Eingriffsabschnitts und des zweiten Eingriffsabschnitts erzeugt wird, zwischen dem Befestigungsbereich des ersten Substrathalters (2014, 3014) und dem Befestigungsbereich des zweiten Substrathalters (2015, 3015) eintritt.

7. Substrathalterpaar nach Anspruch 6, bei dem
einer des ersten Eingriffsabschnitts und des zweiten Eingriffsabschnitt einen Magneten aufweist, sowie einen Stützabschnitt, der eine Verbindungsfläche aufweist und den Magneten hält.

8. Substrathalterpaar nach Anspruch 7, bei dem
der andere des ersten Eingriffsabschnitts und des zweiten Eingriffsabschnitts ist ein ferroelektrischer Körper ist.

9. Substrathalterpaar nach Anspruch 1, bei dem
ein zweiter Halteabschnitt des zweiten Substrathalters (2015, 3015) das zweite Substrat (2017, 3017) berührt, das auf das erste Substrat (2016, 3016) gestapelt und mit diesem verbunden ist, und der zweite Substrathalter (2015, 3015) zusammen mit dem ersten Substrathalter (2014, 3014) das erste Substrat (2016, 3016) und das zweite Substrat (2017, 3017) sandwichartig einklemmt;
das Eingriffselement einen ersten Eingriffsabschnitt aufweist, der auf dem ersten Substrathalter (2014, 3014) vorgesehen ist; und einen zweiten Eingriffsabschnitt, der mit dem ersten Eingriffsabschnitt in Eingriff steht und auf dem zweiten Substrathalter (2015, 3015) vorgesehen ist; und
eine Kontaktfläche zwischen dem ersten Eingriffsabschnitt und dem zweiten Eingriffsabschnitt in Gravitationsrichtung unterhalb einer Verbindungsfläche zwischen dem ersten Substrat und dem zweiten Substrat angeordnet ist.

10. Substrathalterpaar nach Anspruch 9, bei dem
die Kontaktfläche zwischen dem ersten Eingriffsabschnitt und dem zweiten Eingriffsabschnitt unter demjenigen des ersten Halteabschnitts und des zweiten Halteabschnitts angeordnet ist, der in Gravitationsrichtung niedriger positioniert ist.

11. Substrathalterpaar nach einem der vorhergehenden Ansprüche, ferner aufweisend:
ein Eingriffsaufnahmeelement, das auf dem ersten Substrathalter (2014, 3014) vorgesehen ist; und
ein Eingriffselement, das auf dem zweiten Substrathalter (2015, 3015) vorgesehen ist und dem Eingriffsaufnahmeelement zugewandt ist.

12. Substratverbindungsvorrichtung, aufweisend:
das Substrathalterpaar nach einem der Ansprüche 1 bis 11.

13. Substratverbindungsvorrichtung nach Anspruch 12,
ferner aufweisend einen Verbindungsabschnitt, der das erste Substrat, das vom ersten Substrathalter gehalten wird, und das zweite Substrat, das vom zweiten Substrathalter gehalten wird, miteinander verbindet.

14. Verfahren zur Herstellung einer Vorrichtung, aufweisend die Herstellung einer Vorrichtung durch Stapeln von zwei Substraten, wobei das Verfahren aufweist:
Befestigen eines ersten Substrats (2016, 3016) auf einem ersten Befestigungsbereich eines ersten Substrathalters (2014, 3014);
Stapeln eines zweiten Substrats (2017, 3017) und des ersten Substrats (2016, 3016), das von dem ersten Substrathalter (2014, 3014) gehalten wird; und
Fixieren der beiden Substrate in einem gestapelten Zustand, wobei
während des Fixierens ein Staubflusshemmmechanismus verwendet wird, um Staub, der durch das Fixieren mit dem Fixierelement erzeugt wird, daran zu hindern, zwischen dem ersten Substrat (2016, 3016) und dem zweiten Substrat (2017, 3017) einzudringen,
**dadurch gekennzeichnet, dass**
das Verfahren aufweist:
Saugen und Wegnehmen von Staub, bevor er zwischen dem ersten Substrat (2016, 3016) und dem zweiten Substrat (2017, 3017) eintritt, unter Verwendung einer Absaugvorrichtung (2075).

15. Verfahren zur Herstellung einer Vorrichtung nach Anspruch 14, bei dem
der erste Substrathalter (2014, 3014) einen ersten Halteabschnitt, der das erste Substrat (2016, 3016) berührt, und einen ersten Eingriffsabschnitt aufweist, der außerhalb des ersten Halteabschnitts vorgesehen ist;
wobei das Befestigen das Anbringen eines zweiten Substrats (2017, 3017) auf einem zweiten Substrathalter (2015, 3015) mit einem zweiten Halteabschnitt, der das zweite Substrat (2017, 3017) berührt, und einem zweiten Eingriffsabschnitt, der außerhalb des zweiten Halteabschnitts vorgesehen ist, einschließt;
das Stapeln das Stapeln des ersten und des zweiten Substrats (2016, 3016; 2017, 3017) und das einklemmen des ersten und des zweiten Substrats (2016, 3016; 2017, 3017) mit dem ersten Substrathalter (2014, 3014) und dem zweiten Substrathalter (2015, 3015) einschließt; und
das Fixieren ein Eingreifen in den ersten Eingriffsabschnitt und den zweiten Eingriffsabschnitt einschließt, wobei
während des Eingreifens ein Staubflusshemmmechanismus verwendet wird, um Staub, der durch das Eingreifen des ersten Eingriffsabschnitts und des zweiten Eingriffsabschnitts erzeugt wird, daran zu hindern, zwischen dem ersten Halteabschnitt und dem zweiten Halteabschnitt einzudringen.

## Revendications

1. Paire de porte-substrats comprenant :
un premier porte-substrat (2014, 3014) qui possède un premier corps porteur (2022, 3022) portant un premier substrat (2016, 3016) ;
un second porte-substrat (2015, 3015) qui possède un second corps porteur (2023, 3023) portant un second substrat (2017, 3017) ;
dans laquelle le premier porte-substrat (2014, 3014) et le second porte-substrat (2015, 3015) sont configurés pour prendre en sandwich le premier substrat (2016, 3016) et le second substrat (2017, 3017) ;
la paire de porte-substrats comprenant en outre un mécanisme de prévention d'entrée de poussière configuré pour empêcher la poussière d'entrer entre le premier substrat (2016, 3016) et le second substrat (2017, 3017) ;
**caractérisée en ce que** :
la paire de porte-substrats comprend un appareil d'aspiration (2075) configuré pour aspirer la poussière, avant qu'elle n'entre entre le premier substrat (2016, 3016) et le second substrat (2017, 3017), et retirer la poussière d'entre le premier porte-substrat (2014, 3014) et le second porte-substrat (2015, 3015).

2. Paire de porte-substrats selon la revendication 1, dans laquelle
le mécanisme de prévention d'entrée de poussière comporte une région de piégeage de poussière configurée pour piéger la poussière et prévue sur au moins un du premier porte-substrat (2014, 3014) et du second porte-substrat (2015, 3015).

3. Paire de porte-substrats selon la revendication 2, dans laquelle
la région de piégeage de poussière inclut un premier trou traversant (2101, 2102) relié à un tube d'aspiration et prévu entre un élément de mise en prise et au moins une région de montage pour monter un substrat sur l'au moins un du premier porte-substrat (2014, 3014) et du second porte-substrat (2015, 3015) et configuré pour aspirer la poussière à travers le premier trou traversant.

4. Paire de porte-substrats selon la revendication 3, dans laquelle
la région de piégeage de poussière inclut un troisième trou traversant à une position qui n'est pas entre la périphérie de la région de montage et l'élément de mise en prise, et
le troisième trou traversant est relié à un tube d'aspiration.

5. Paire de porte-substrats selon l'une quelconque des revendications 1 à 4, dans laquelle
l'élément de mise en prise inclut une première section de mise en prise prévue à l'extérieur d'une première région de montage du premier porte-substrat (2014, 3014) pour monter le premier substrat (2016, 3016) et une seconde section de mise en prise prévue à l'extérieur d'une seconde région de montage du second porte-substrat (2015, 3015) pour monter le second substrat (2017, 3017), et
mécanisme de prévention d'entrée de poussière inclut une partie en saillie prévue sur au moins une d'une surface de mise en prise de la première section de mise en prise et d'une surface de mise en prise de la seconde section de mise en prise, pour obtenir un contact ponctuel ou un contact linéaire avec la surface de mise en prise de l'autre de la première section de mise en prise et de la seconde section de mise en prise.

6. Paire de porte-substrats selon l'une quelconque des revendications 1 à 5, dans laquelle
l'élément de mise en prise inclut une première section de mise en prise prévue à l'extérieur d'une région de montage du premier porte-substrat (2014, 3014) pour monter le premier substrat (2016, 3016) et une seconde section de mise en prise prévue à l'extérieur d'une région de montage du second porte-substrat (2015, 3015) pour monter le second substrat (2017, 3017), et
mécanisme de prévention d'entrée de poussière est configuré pour empêcher la poussière générée par la mise en prise de la première section de mise en prise et de la seconde section de mise en prise d'entrer entre la région de montage du premier porte-substrat (2014, 3014) et la région de montage du second porte-substrat (2015, 3015).

7. Paire de porte-substrats selon la revendication 6, dans laquelle
l'une de la première section de mise en prise et de la seconde section de mise en prise inclut un aimant et une section de support qui possède une surface de liaison et supporte l'aimant.

8. Paire de porte-substrats selon la revendication 7, dans laquelle
l'autre de la première section de mise en prise et de la seconde section de mise en prise est un corps ferroélectrique.

9. Paire de porte-substrats selon la revendication 1, dans laquelle
une seconde partie porteuse du second porte-substrat (2015, 3015) entre en contact avec le second substrat (2017, 3017) qui est empilé sur et lié avec le premier substrat (2016, 3016), et le second porte-substrat (2015, 3015), en conjugaison avec le premier porte-substrat (2014, 3014), prend en sandwich le premier substrat (2016, 3016) et le second substrat (2017, 3017) ;
l'élément de mise en prise inclut une première section de mise en prise prévue sur le premier porte-substrat (2014, 3014) ; et une seconde section de mise en prise qui se met en prise avec la première section de mise en prise et est prévue sur le second porte-substrat (2015, 3015) ; et
une surface de contact entre la première section de mise en prise et la seconde section de mise en prise est positionnée en dessous d'une surface de liaison entre le premier substrat et le second substrat dans un sens de la gravité.

10. Paire de porte-substrats selon la revendication 9, dans laquelle
la surface de contact entre la première section de mise en prise et la seconde section de mise en prise est positionnée en dessous de celle de la première partie de support et de la seconde partie de support qui est positionnée le plus bas, dans le sens de la gravité.

11. Paire de porte-substrats selon l'une quelconque des revendications précédentes, comprenant en outre :
un élément de réception de mise en prise prévu sur le premier porte-substrat (2014, 3014) ; et
un élément de mise en prise prévu sur le second porte-substrat (2015, 3015) et faisant face à l'élément de réception de mise en prise.

12. Appareil de liaison de substrats comprenant :
la paire de porte-substrats selon l'une quelconque des revendications 1 à 11.

13. Appareil de liaison de substrats selon la revendication 12,
comprenant en outre une section de liaison qui lie le premier substrat porté par le premier porte-substrat et le second substrat porté par le second porte-substrat l'un à l'autre.

14. Procédé de fabrication de dispositif comprenant la fabrication d'un dispositif par empilement de deux substrats, le procédé comprenant :
le montage d'un premier substrat (2016, 3016) sur une première région de montage d'un premier porte-substrat (2014, 3014) ;
l'empilement d'un second substrat (2017, 3017) et du premier substrat (2016, 3016) porté par le premier porte-substrat (2014, 3014) ; et
la fixation des deux substrats dans un état empilé, dans lequel
pendant la fixation, l'utilisation d'un mécanisme de prévention d'entrée de poussière pour empêcher la poussière générée par la fixation de l'élément de fixation d'entrer entre le premier substrat (2016, 3016) et le second substrat (2017, 3017),
**caractérisé en ce que** le procédé comprend :
l'aspiration et le retrait de poussière, avant qu'elle n'entre entre le premier substrat (2016, 3016) et le second substrat (2017, 3017), au moyen d'un appareil d'aspiration (2075).

15. Procédé de fabrication de dispositif selon la revendication 14, dans lequel
le premier porte-substrat (2014, 3014) inclut une première partie porteuse qui entre en contact avec le premier substrat (2016, 3016) et une première section de mise en prise prévue à l'extérieur de la première partie porteuse ;
dans lequel le montage comporte le montage d'un second substrat (2017, 3017) sur un second porte-substrat (2015, 3015) incluant une seconde partie porteuse qui entre en contact avec le second substrat (2017, 3017) et une seconde partie de mise en prise prévue à l'extérieur de la seconde partie porteuse ;
l'empilement inclut l'empilement des premier et second substrats (2016, 3016 ; 2017, 3017) et la prise en sandwich des premier et second substrats (2016, 3016 ; 2017, 3017) avec le premier porte-substrat (2014, 3014) et le second porte-substrat (2015, 3015) ;
la fixation comporte la mise en prise de la première section de mise en prise et de la seconde section de mise en prise l'une avec l'autre, dans lequel
pendant la mise en prise, mécanisme de prévention d'entrée de poussière est utilisé pour empêcher la poussière générée par la mise en prise de la première section de mise en prise et de la seconde section de mise en prise d'entrer entre la première partie porteuse et la seconde partie porteuse.
